(19) Europäisches Patentamt
European Patent Office
Office européen des brevets

(11) **EP 1 593 201 B1**

## (12) EUROPÄISCHE PATENTSCHRIFT

(45) Veröffentlichungstag und Bekanntmachung des Hinweises auf die Patenterteilung:
**23.10.2013  Patentblatt 2013/43**

(21) Anmeldenummer: 04707478.6

(22) Anmeldetag: **03.02.2004**

(51) Int Cl.:
*H03M 13/27* (2006.01)   *H03M 13/29* (2006.01)
*H04L 1/00* (2006.01)

(86) Internationale Anmeldenummer:
**PCT/DE2004/000167**

(87) Internationale Veröffentlichungsnummer:
**WO 2004/073167 (26.08.2004 Gazette 2004/35)**

(54) **VERFAHREN UND SCHALTUNG ZUR ADRESSGENERIERUNG VON PSEUDO-ZUFALLS-INTERLEAVERN ODER -DEINTERLEAVERN**

METHOD AND CIRCUIT FOR GENERATING ADDRESSES OF PSEUDO-RANDOM INTERLEAVERS OR DEINTERLEAVERS

PROCEDE ET CIRCUIT POUR LA GENERATION D'ADRESSES D'ENTRELACEURS OU DE DESENTRELACEURS PSEUDO-ALEATOIRES

(84) Benannte Vertragsstaaten:
**DE FR GB**

(30) Priorität: **14.02.2003  DE 10306302**

(43) Veröffentlichungstag der Anmeldung:
**09.11.2005  Patentblatt 2005/45**

(73) Patentinhaber: **Intel Mobile Communications GmbH**
**85579 Neubiberg (DE)**

(72) Erfinder:
• **HERNDL, Thomas**
**Biedermannsdorf 2362 (AT)**
• **BERKMANN, Jens**
**81375 München (DE)**

(74) Vertreter: **Patentanwälte Lambsdorff & Lange**
**Dingolfinger Strasse 6**
**81673 München (DE)**

(56) Entgegenhaltungen:
EP-A- 1 139 572        WO-A-00/35101
WO-A-00/60751        US-A1- 2002 046 371
US-A1- 2002 159 423     US-B1- 6 314 534

• **MASERA G ET AL: "Low-cost IP-blocks for UMTS turbo decoders" PROC. OF THE 27TH EUROPEAN SOLID-STATE CIRCUITS CONFERENCE, VILLACH, AUSTRIA, Seiten 472-475, XP002287755 2001, Paris, France, Frontier Group, France ISBN: 2-914601-00-X**
• **"Universal Mobile Telecommunications System (UMTS);Multiplexing and channel coding (FDD) (3GPP TS 25.212 version 3.5.0 Release 1999); ETSI TS 125 212" ETSI STANDARDS, EUROPEAN TELECOMMUNICATIONS STANDARDS INSTITUTE, SOPHIA-ANTIPO, FR, Bd. 3-R1, Nr. V350, Dezember 2000 (2000-12), XP014008355 ISSN: 0000-0001**

**Beschreibung**

Die Erfindung betrifft ein Verfahren und eine Vorrichtung zur Berechnung einer Verschachtelungs- oder Entschachtelungs-Adresse bezüglich einer Symbolfolge auf der Basis einer Verschachtelungsvorschrift (Permutation).

In Kommunikationssystemen, beispielsweise Mobilfunksystemen, wird das zu übertragende Signal einer Kanalcodierung und einer Verschachtelung (Interleaving) unterzogen. Beide Maßnahmen verleihen dem zu übertragenden Signal eine gewisse Robustheit. Bei der Kanalcodierung wird durch gezieltes Einbringen von Redundanz in das zu übertragende Signal ein effektiver Fehlerschutz geschaffen. Durch die Verschachtelung wird erreicht, dass durch Kanalstörungen bewirkte Gruppenbitfehler zeitlich verteilte Symbole des ursprünglichen, nicht verschachtelten bzw. des empfangenen entschachtelten Signals betreffen und damit eher tolerierbare Einzelbitfehler darstellen.

Die im Sender erfolgende Verschachtelung der auszusendenden Symbolfolge erfolgt datenblockweise, d.h. die Bits eines jeden Datenblocks werden nach der gleichen Verschachtelungsvorschrift vom senderseitigen Verschachteler permutiert. Die Rücktransformation, mit der die Bits wieder in ihre ursprüngliche Reihenfolge gebracht werden, erfolgt im Empfänger mittels eines Entschachtelers.

Turbo- Codes stellen eine besonders leistungsfähige Klasse von Kanal- Codes dar. Turbo- Codes werden durch zwei systematische parallel verkettete Faltungscodierer erzeugt, die über einen Verschachteler miteinander verbunden sind. Die Verschachtelung ist bei der Turbo- Codierung somit Bestandteil der Code- Erzeugung. Durch den Verschachteler wird eine Codiererinterne  pseudo- zufällige Permutierung der Symbolfolge vorgenommen. Die Decodierung des Turbo- Codes erfolgt auf iterativem Wege im Empfänger. Die dem Turbo- Code zugrunde liegenden beiden Faltungs- Codes werden alternierend decodiert, wobei die beiden hierfür eingesetzten Faltungscodierer über einen Verschachteler miteinander verbunden sind. In jedem Decodierschritt der Iteration erzeugt der zweite Faltungsdecodierer eine Zuverlässigkeitsinformation in Form eines Stroms verschachtelter Soft- Bit- Werte, die im nächsten Decodierschritt vom ersten Faltungscodierer als zusätzliche Eingangsinformation genutzt wird. Da diese Zuverlässigkeitsinformation als nicht- verschachtelte Symbolfolge vom ersten Faltungsdecodierer benötigt wird, muss sie zuvor von einem Entschachteler entschachtelt werden. Jeder Decodierschritt umfasst somit eine Verschachtelung und eine Entschachtelung einer Symbolfolge.

Die internen Ver- bzw. Entschachteler eines Turbo-Decodierers arbeiten nach einer Pseudo-Zufalls-Verschachtelungsvorschrift. Für den UMTS-(Universal Mobile Telecommunications System-)Standard ist diese Vorschrift in 3GPP TS 25.212 V3.11.0 (2002-09) in dem Kapitel 4.2.3.2 angegeben.

Jede Verschachtelung einer Symbolfolge bestehend aus K Symbolen (K wird als Blocklänge bezeichnet) lässt sich mathematisch als eine Permutation der Folge 0, 1, 2, ..., K- 1 aus ganzen Zahlen angegeben. Die Permutation gibt an, wie die Symbole der Symbolfolge bei der Verschachtelung umzuordnen sind. Der UMTS- Standard weist eine variable Blocklänge $40 \leq K \leq 5114$ auf. Damit werden sämtliche im UMTS- Standard möglichen Verschachtelungen durch 5075 Permutationen (unterschiedlicher Länge) bestimmt.

Anstelle einer expliziten Angabe dieser 5075 Permutationen enthält der UMST-Standard eine generische Erzeugungsregel, mit welcher bei Kenntnis der Blocklänge K aus einer nicht-verschachtelten Symbolfolge die zugehörige verschachtelte  Symbolfolge zu generieren ist. Diese Erzeugungsregel kann auch als Regel zur Berechnung der die Umsortierung der Symbolfolge definierenden Permutation aufgefasst bzw. verwendet werden.

Bisher wird die Ver- und Entschachtelung im Turbo-Decodierer folgendermaßen durchgeführt: Zunächst wird z.B. mittels eines digitalen Signalprozessors (DSP) aus der im Standard spezifizierten Erzeugungsregel die Permutation für die aktuell verwendete Blocklänge K berechnet. Diese Permutation wird in einem Permutationsmuster-Datenspeicher abgelegt, der 5114 Speicherwörter einer Wortbreite von 13 Bit, d.h. eine Größe von etwa 65 kBit, haben muss. Beim Verschachteln des Datenblocks wird für jedes Symbol der nicht-verschachtelten Symbolfolge in dem Permutationsmuster-Datenspeicher nachgeschlagen, wo dieses Symbol in der verschachtelten Symbolfolge zu platzieren ist. Konstruktiv erfolgt dies z.B. in der Weise, dass die Symbole gemäß ihrer zeitlichen Reihenfolge in einen Symbolspeicher geschrieben und mit den durch die Permutationswerte gegebenen Adressen aus dem Speicher ausgelesen werden. Die Entschachtelung funktioniert in analoger Weise mittels eines Permutationsmuster-Datenspeichers gleicher Größe, in welchem die inverse Permutation abgelegt ist. Nachteilig an dieser Vorgehensweise ist der hohe Speicherplatzbedarf für den Permutationsmuster-Datenspeicher.

Die Tatsache, dass die Verschachtelungsvorschrift in Form einer Permutation-Erzeugungsregel vorliegt, ermöglicht es, für jedes Symbol der nicht-verschachtelten Symbolfolge den zugehörigen aktuellen Permutationswert "on-the-fly" zu berechnen. Dabei erübrigt sich die Vorausberechnung und Abspeicherung der gesamten Permutation in einem Permutationsmuster-Datenspeicher. Wichtig ist in diesem Fall jedoch, dass die Einzelberechnung der Permutationswerte immer ausreichend schnell erfolgt, weil ansonsten nachfolgende Rechenoperationen (im Turbo-Decodierer die Faltungsdecodierung) verzögert werden.

Die im UMTS-Standard definierte Regel zum Verschachteln einer Symbolfolge basiert auf einer Koordinatentransformation in einer Rechteckmatrix. Zunächst wird in Abhängigkeit von der bekannten Blocklänge K die Dimension der Rechteckmatrix definiert. Dann werden die zu verschachtelnden Symbole der Symbolfolge zeilenweise in die Rechteckmatrix eingeschrieben. Freibleibende Matrixelemente werden mit Füllzeichen aufgefüllt ("padding"). Nach dem Auffüllen der Rechteckmatrix wird eine Matrix-Koordinatentransformation vorgenommen, welche eine Interzeilenpermutation und eine Intrazeilenpermutation umfasst. Durch spaltenweises Auslesen der transformierten Rechteckmatrix wird die verschachtelte, mit Füllzeichen aufgefüllte Symbolfolge erzeugt. Durch Entfernen ("pruning") der Füllzeichen wird aus der verschachtelten Symbolfolge mit Füllzeichen die verschachtelte Symbolfolge ohne Füllzeichen generiert.

Zur Berechnung der zugehörigen Permutation wird statt der Symbolfolge die Folge 0, 1, 2, ..., K- 1 der Indizes der Symbole betrachtet und in gleicher Weise wie oben beschrieben prozessiert. Das Auffüllen der Rechteckmatrix erfolgt mit ungültigen Indizes K, K+1, ..., Anzahl der Matrixelemente- 1. Beim Auslesen der transformierten Rechteckmatrix werden die permutierten unzulässigen Indizes erkannt und verworfen.

Hierbei ergibt sich die folgende Schwierigkeit: Bei der "on- the- fly"- Berechnung der Permutationswerte (d.h. der permutierten Indizes) zeigt es sich erst nach der Berechnung eines solchen Wertes, ob es sich bei diesem Wert tatsächlich um einen gültigen Permutationswert (welcher einem Symbol der Symbolfolge zugeordnet ist) oder um einen Nicht- Permutationswert (welcher einem der Füllzeichen zugeordnet ist) handelt: Gültige Permutationswerte sind kleiner als K. Werte, die gleich oder größer als K sind, beziehen sich auf eine mit einem Füllzeichen aufgefüllte Position der Rechteckmatrix und müssen entfernt werden. Durch die Berechnung eines ungültigen Wertes (d.h. einer ungültigen Adresse zum Auslesen des Symbols- Speichers) geht jedoch Zeit verloren. Die "on- the- fly" Entschachtelung muss solange angehalten werden, bis wieder ein Permutationswert (gültige Adresse) berechnet wird. Da es möglich ist, dass nacheinander mehrere ungültige Werte berechnet werden, kann es zu längeren Unterbrechungen bei der Berechnung der Permutationswerte kommen. Nachfolgende Berechnungsschritte werden zu nicht vorhersehbaren Zeitpunkten und über eine nicht vorhersehbare Dauer (Latenz) verzögert. Dadurch wird der Datendurchsatz reduziert. Darüber hinaus wird die Steuerbarkeit des Gesamtrechenflusses wesentlich erschwert. Z.B. muss bei einem Turbo- Decodierer der die entschachtelte Symbolfolge entgegennehmende Faltungsdecodierer ständig für variierende Zeitdauern angehalten werden.

Der Erfindung liegt die Aufgabe zugrunde, ein Verfahren zur "on- the- fly"- Berechnung von Verschachtelungs- oder Entschachtelungs- Adressen anzugeben, welches einen hohen Datendurchsatz und eine gute Steuerbarkeit von nachfolgenden Berechnungsabläufen gestattet. Ferner zielt die Erfindung darauf ab, eine Vorrichtung mit den vorstehend genannten Eigenschaften zur "on- the- fly"- Berechnung von Verschachtelungs- oder Entschachtelungs- Adressen anzugeben.

Das Dokument "MASERA G ET AL: 'Low- cost IP- blocks for UMTS turbo decoders', PROC. OF THE 27TH EUROPEAN SOLID- STATE CIRCUITS CONFERENCE 2001, VILLACH, AUSTRIA, Seiten 472- 475, XP002287755" beschreibt eine Architektur zur Implementierung eines UMTS Turbo- Dekoders mit SISO (Soft- Input Soft- Output)- und Interleaver- Einheit.

Das Dokument US 2002/159423 A1 beschreibt eine Interleaver-Einheit für einen Turbo-Dekoder. Mit der Interleaver-Einheit können Zwischenergebnisse für den Turbo-Dekoder gespeichert werden.

Die der Erfindung zugrunde liegende Aufgabenstellung wird durch die Merkmale der unabhängigen Patentansprüche gelöst.

Die Erfindung geht von einer Verschachtelungsvorschrift aus, welche anhand einer Rechteckmatrix, einer Schreib-Zuordnungsvorschrift der Symbole der nicht verschachtelten Symbolfolge zu den Matrixkoordinaten, dem Auffüllen der Rechteckmatrix mit Füllzeichen, einer Matrix-Koordinatentransformation und einer Lese-Zuordnungsvorschrift der transformierten Matrixkoordinaten zu der ver- oder entschachtelten Symbolfolge definiert ist. Nach einem ersten Aspekt der Erfindung werden zur Berechnung einer bestimmten Verschachtelungs- oder Entschachtelungs-Adresse I (k) für die Adressierung eines Symbolspeichers in Abhängigkeit von einem Zeitschritt k in jedem Zeitschritt k die folgenden Schritte durchgeführt: Es wird ein Koordinatenpaar der Rechteckmatrix in Abhängigkeit von k berechnet. Anschließend wird das berechnete Koordinatenpaar zur Berücksichtigung von hinzugefügten Füllzeichen korrigiert. In einem weiteren Schritt wird aus dem korrigierten Koordinatenpaar ein transformiertes Koordinatenpaar durch Ausführung der Matrix-Koordinatentransformation ermittelt. Schließlich wird eine gültige Verschachtelungs- oder Entschachtelungs-Adresse (Permutationswert) aus dem transformierten Koordinatenpaar gemäß der Schreib-Zuordnungsvorschrift berechnet.

Der der Erfindung zugrundeliegende Gedanke besteht darin, durch eine Korrektur des Koordinatenpaars das Vorhandensein von Füllzeichen bereits im Berechnungsablauf zu berücksichtigen und damit zu erreichen, dass in jedem Zeitschritt k ausschließlich gültige Verschachtelungs- oder Entschachtelungs-Adressen berechnet werden. Mit anderen Worten enthält der Rechenablauf zur Ermittlung der Adresse I(k) eine interne, analytische "Depruning"-Operation, die dafür sorgt, dass allein gültige Adressen I(k) berechnet werden. Das Auftreten von Lücken in der berechneten Adressenfolge (durch nachträgliches Entfernen von ungültigen Adressen) ist ausgeschlossen. Damit kann eine höhere Datenrate bedient werden und andererseits wird durch die Synchronität der berechneten Adressen I(k) mit der nicht ver- oder entschachtelten Symbolfolge - d.h. dem Zeitschritt k - der Kontrollaufwand für nachfolgende Rechenabläufe wesentlich reduziert.

Bei einer Matrixtransformation, welche eine Matrix-Interzeilenpermutation und eine Matrix-Intrazeilenpermutation umfasst, kennzeichnet sich eine vorteilhafte Durchführung des Korrekturschrittes durch die folgenden Teilschritte:

Mehrfaches Nachschlagen von ersten Korrekturwerten aus einer ersten Tabelle, welche bezüglich einer bestimmten Zeile der Rechteckmatrix zu jeder Spaltenkoordinate eine Information bezüglich der Anzahl der Füllzeichen angibt, die in der bestimmten Zeile vom Zeilenanfang bis zur betrachteten Spaltenkoordinate enthalten sind; und Korrigieren der Spaltenkoordinate um den zuletzt nachgeschlagenen ersten Korrekturwert. Ein Vorteil dieses Verfahrens besteht in der einfachen Berechnung der ersten Tabelle.

Ein ebenfalls vorteilhafte, alternative Verfahrensvariante umfasst die Teilschritte des einmaligen Nachschlagens eines zweiten Korrekturwertes aus einer zweiten Tabelle, welche bezüglich einer bestimmten Zeile der Rechteckmatrix zu jeder Spaltenkoordinate eine Information bezüglich der Anzahl der Füllzeichen angibt, die in der bestimmten Zeile vom Zeilenanfang bis zur betrachteten Spaltenkoordinate und von der betrachteten Spaltenkoordinate bis zum Zeilenende enthalten sind; und Korrigieren der Spaltenkoordinate um den nachgeschlagenen zweiten Korrekturwert. Der Vorteil dieser Verfahrensvariante besteht darin, dass ein einmaliges Nachschlagen in der zweiten Tabelle zur Ermittlung der benötigten Information für den Korrekturschritt ausreicht.

Anstelle der Verschachtelungs- oder Entschachtelungs-Adresse $I(k)$ kann zur Adressierung des Symbolspeichers auch die inverse Verschachtelungs- oder Entschachtelungs-Adresse $I^{-1}(k)$ eingesetzt werden. Nach einem zweiten Aspekt der Erfindung werden zur Berechnung einer bestimmten inversen Verschachtelungs- oder Entschachtelungs-Adresse $I^{-1}(k)$ für die Adressierung eines Symbolspeichers in Abhängigkeit von einem Zeitschritt $k$ in jedem Zeitschritt $k$ die folgenden Schritte durchgeführt: Berechnen eines Koordinatenpaares der Rechteckmatrix in Abhängigkeit von $k$; Ermitteln eines transformierten Koordinatenpaares zu dem Koordinatenpaar durch Ausführung der inversen Matrix-Koordinatentransformation; und Berechnen einer gültigen inversen Verschachtelungs- oder Entschachtelungs-Adresse $I^{-1}(k)$ aus dem transformierten Koordinatenpaar unter Berücksichtigung von Füllzeichen, wodurch zu jedem berechneten Koordinatenpaar eine gültige inverse Verschachtelungs- oder Entschachtelungs-Adresse $I^{-1}(k)$ berechnet wird.

Der wesentliche Unterschied zu dem zuvor beschriebenen Verfahren besteht darin, dass in diesem Fall zunächst der Koordinaten-Transformationsschritt und dann der Schritt zur Berücksichtigung der Füllzeichen durchgeführt wird.

Bei einer Matrixtransformation, die eine Matrix-Interzeilenpermutation und eine Matrix-Intrazeilenpermutation umfasst, kennzeichnet sich eine vorteilhafte Durchführung des Korrekturschrittes zur Berücksichtigung der Füllzeichen durch die Vornahme der folgenden Teilschritte: Einmaliges Nachschlagen von dritten Korrekturwerten aus einer dritten Tabelle, welche bezüglich einer bestimmten Zeile der Rechteckmatrix zu jeder Spaltenkoordinate eine Information bezüglich der Anzahl der Füllzeichen angibt, die in der bestimmten Zeile vom Zeilenanfang bis zur Spaltenkoordinate vor der betrachteten Spaltenkoordinate enthalten sind. Bei dieser Ausführungsvariante entfällt somit ein mehrfaches Nachschlagen von Korrekturwerten in der dritten Tabelle (welche im Wesentlichen mit der Tabelle gemäß dem ersten Aspekt der Erfindung vergleichbar ist).

Bei der erfindungsgemäßen Vorrichtung handelt es sich bei den Datenspeichern zum Speichern der Tabellen vorzugsweise um Single-Port-Datenspeicher. Gegenüber der Verwendung von Dual-Port-Datenspeicher weist diese Lösung Vorteile bei der Portierung der Algorithmen auf verschiedene Technologien auf.

Weitere vorteilhafte Ausgestaltungen der Erfindung sind in den Unteransprüchen angegeben.

Nachfolgend wird die Erfindung anhand von Ausführungsbeispielen unter Bezugnahme auf die Zeichnung erläutert; in dieser zeigt:

Fig. 1     eine Prinzipdarstellung eines Verschachtelers;

Fig. 2     eine erste Architektur eines Verschachtelers;

Fig. 3     eine zweite Architektur eines Verschachtelers;

Fig. 4     eine Prinzipdarstellung eines Entschachtelers;

Fig. 5     eine erste Architektur eines Entschachtelers;

Fig. 6     eine zweite Architektur eines Entschachtelers;

Fig. 7     ein Blockschaltbild eines bekannten Turbo-Codierers zur Erzeugung eines Turbo-Codes;

Fig. 8     ein Blockschaltbild eines bekannten Turbo-Decodierers zur Decodierung eines Turbo-codierten Datenstroms;

Fig. 9     eine Rechteckmatrix, die transformierte Rechteckmatrix und das Verschachtelungs-Permutationsmuster $I$ für das Beispiel R=5, C=10, K=43;

Fig. 10    eine transformierte Rechteckmatrix mit zwei vollständig mit Füllzeichen belegten Zeilen;

Fig. 11    die Tabellen **prucol** und **pruleftcol** sowie die dazugehörige transformierte Rechteckmatrix mit R=5, C=20;

Fig. 12    eine erläuternde Darstellung des Korrekturalgorithmus nach dem ersten Ausführungsbeispiel der Erfindung;

Fig. 13    eine Darstellung des Algorithmus sowie einer Schaltung zum Berechnen der Adressen I(k) nach dem ersten Ausführungsbeispiel der Erfindung;

Fig. 14    die Tabellen **prucol** und **prutotcol** sowie die dazugehörige transformierte Rechteckmatrix mit R=5, C=20;

Fig. 15    eine Darstellung des Korrekturalgorithmus sowie einer Schaltung zum Berechnen von korrigierten Matrixkoordinaten  nach dem zweiten Ausführungsbeispiel der Erfindung;

Fig. 16    die transformierte Rechteckmatrix und das inverse Verschachtelungs-Permutationsmuster $I^{-1}$ für das Beispiel R=5, C=10, K=43; und

Fig. 17    eine Darstellung des Algorithmus sowie einer Schaltung zum Berechnen der inversen Adressen $I^{-1}(k)$ nach dem dritten Ausführungsbeispiel der Erfindung.

## 1. Verschachteler und Entschachteler

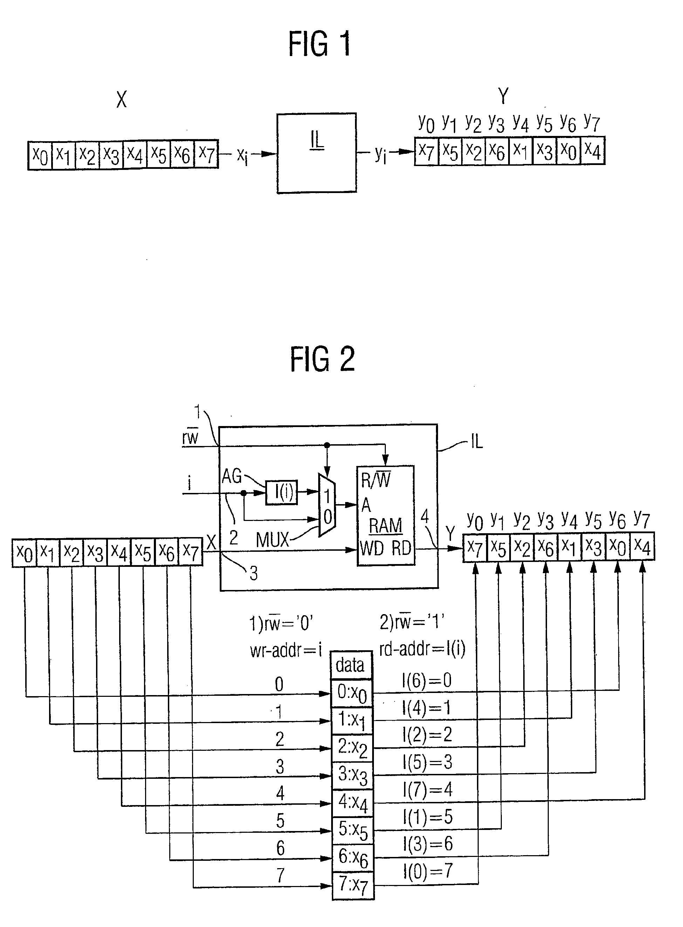

Die Fig. 1 verdeutlicht das generelle Prinzip einer Verschachtelung. Ein Verschachteler (Interleaver) IL nimmt eine nicht- verschachtelte Symbolfolge X= $\{x_0, x_1, x_2, ..., x_{K-1}\}$ entgegen, sortiert die einzelnen Symbole $x_i$, i=0, 1, ..., K-1, um und gibt eine verschachtelte Symbolfolge Y= $\{y_0, y_1, y_2, ..., y_{K-1}\}$ aus. K bezeichnet die der Verschachtelung zugrunde liegende Länge der Symbolfolge, d.h. die Blocklänge. Da die Verschachtelung blockweise erfolgt, wird der Verschachteler IL auch als Blockverschachteler bezeichnet. Fig. 1 zeigt ein Beispiel für K = 8. Es wird deutlich, dass das Verschachteln ein Umsortieren der Symbole der Eingangs- Symbolfolge X in ihrer zeitlichen Aufeinanderfolge ist. Die Vorschrift, gemäß welcher die Umsortierung vorgenommen wird, lässt sich direkt an der verschachtelten Symbolfolge Y ablesen.

Diese Vorschrift lässt sich auf zwei verschiedene Weisen interpretieren, nämlich durch eine Funktion I(i) oder durch die inverse Funktion $I^{-1}(i)$.

   i) der i-te Wert $y_i$ der verschachtelten Ausgangs-Symbolfolge wurde von der Position I(i) der ursprünglichen, nicht verschachtelten Eingangs-Symbolfolge bezogen. D.h. $y_i = x_{I(i)}$.
   ii) der i-te Wert $x_i$ der ursprünglichen, nicht verschachtelten Eingangs-Symbolfolge wird auf die Position $I^{-1}(i)$ der verschachtelten Ausgangs-Symbolfolge abgebildet. D.h. $y_{I^{-1}(i)} = x_i$.

Im folgenden wird die Sequenz **I**= (I (0), I (1), ..., I (K- 1) ) aus Indizes als Verschachtelungs- Permutationsmuster und die Sequenz $\mathbf{I^{-1}}$= ($I^{-1}$ (0), $I^{-1}$ (1), ..., $I^{-1}$ (K- 1) ) aus Indizes als inverses Verschachtelungs- Permutationsmuster bezeichnet.

Fig. 2 zeigt ein erstes Implementierungsbeispiel des Verschachtelers IL aus Fig. 1 nach dem Stand der Technik. Der Verschachteler IL umfasst einen Symbolspeicher RAM, einen Zwei-Wege-Multiplexer MUX und einen Adressgenerator AG, welcher das Verschachtelungs-Permutationsmuster I(i) generiert.

Der Verschachteler IL weist einen ersten Eingang 1 auf, an welchem ein Schreib-/Lesesignal $\overline{rw}$ anliegt. Ein zweiter Eingang 2 nimmt ein Adresssignal i entgegen, das dem Zeitschrittindex i der Eingangs-Symbolfolge X entspricht und z.B. durch einen Zähler erzeugt werden kann. An einem dritten Eingang 3 liegt die Eingangs-Symbolfolge X an.

Das Schreib-/Lesesignal $\overline{rw}$ wird der Schreib-Lese-Umschaltung $R/\overline{W}$ des Symbolspeichers RAM und ferner dem Steuereingang des Multiplexers MUX zugeführt. Es kann die Werte $\overline{rw}$=0 (Schreiben) und $\overline{rw}$=1 (Lesen) annehmen. Das Adresssignal i liegt an dem Eingang des Adressgenerators AG sowie an dem dem Wert $\overline{rw}$=0 zugeordneten Eingang des Multiplexers MUX an. Das Ausgangssignal des Adressgenerators AG ist dem anderen Eingang ($\overline{rw}$=1) des Multi-plexers MUX zugeführt. Der Ausgang des Multiplexers MUX ist mit einem Adresseingang A des Symbolspeichers RAM verbunden.

Der Symbolspeicher RAM weist ferner einen Schreib-Dateneingang WD und einen Lese-Datenausgang RD auf. Dem Schreib-Dateneingang  WD ist die über den Eingang 3 erhaltene Symbolfolge X zugeführt, der Schreib-Datenausgang RD gibt über einen Ausgang 4 des Verschachtelers IL die verschachtelte Symbolfolge Y aus.

Im unteren Teil der Fig. 2 ist die Arbeitsweise des Verschachtelers IL veranschaulicht:

   In einem ersten Schritt wird die Symbolfolge X der Länge K in den Symbolspeicher RAM geschrieben ($\overline{rw}$=0; i=0, 1, 2..., K- 1) . Die am Adresseingang A anliegende Schreibadressierung entspricht direkt dem Eingangs- Zeitschrittindex i.

In einem zweiten Schritt werden Symbole aus dem Symbolspeicher RAM ausgelesen ($\overline{rw}$=1, i=0, 1, 2, ..., K-1), wobei zur Adressierung des Symbolspeichers RAM die Funktion I (i) eingesetzt wird. I (i) zeigt auf diejenige Adresse des Symbolspeichers RAM, von wo ein Symbol genommen und zum Ausgangs- Zeitschrittindex i ausgegeben werden soll.

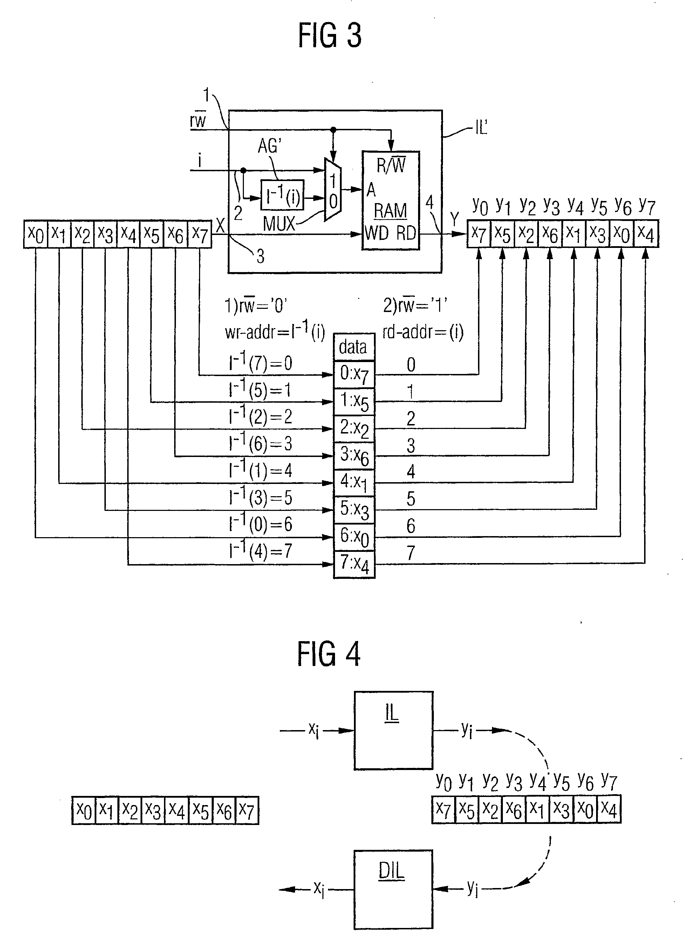

Die in Fig. 2 erläuterte Adressierung mit I(i) orientiert sich an dem Zeitschrittindex i der nicht verschachtelten Symbolfolge X und betrifft den Lesevorgang. Eine alternative Architektur eines Verschachtelers IL' ist in Fig. 3 dargestellt. Diese Architektur unterscheidet sich dadurch von der in Fig. 2 dargestellten Anordnung, dass ein Adressgenerator AG', der die inverse Funktion I$^{-1}$(i) ausführt, mit dem dem Wert $\overline{rw}$=0 zugeordneten Eingang des Multiplexers MUX verbunden ist. In diesem Fall orientiert sich die Adressierung an dem Zeitschrittindex i der verschachtelten Symbolfolge Y. Dies bewirkt, dass die Adressgenerierung vom Adressgenerator AG' beim Schreibvorgang ($\overline{rw}$=0) und nicht beim Lesevorgang $\overline{rw}$=1 (wie bei dem Verschachteler IL der Fig. 2) durchgeführt wird.

Mit wr- addr werden in den Fig. 2 und 3 die Schreibadressen und mit rd- addr die Leseadressen für die Speicheradressierung bezeichnet. Für die in Fig. 2 dargestellte Architektur gilt wr- addr=i (Schreibvorgang) und rd- addr=I (i) (Lesevorgang) . Für die in Fig. 3 dargestellte Architektur gilt wr- addr=I$^{-1}$ (i) (Schreibvorgang) und rd- addr=i (Lesevorgang) .

In Bezug auf das logische Eingangs-/Ausgangsverhalten sind die beiden Verschachteler IL und IL' identisch.

Fig. 4 zeigt das Prinzip eines Entschachtelers DIL (Deinterleaver). Der Entschachteler DIL nimmt eingangsseitig die verschachtelte Symbolfolge Y entgegen und gibt ausgangsseitig die ursprüngliche, entschachtelte Symbolfolge X aus. Mit anderen Worten macht der Entschachteler DIL die vom Verschachteler IL, IL' vorgenommene Umsortierung des Datenstroms wieder rückgängig.

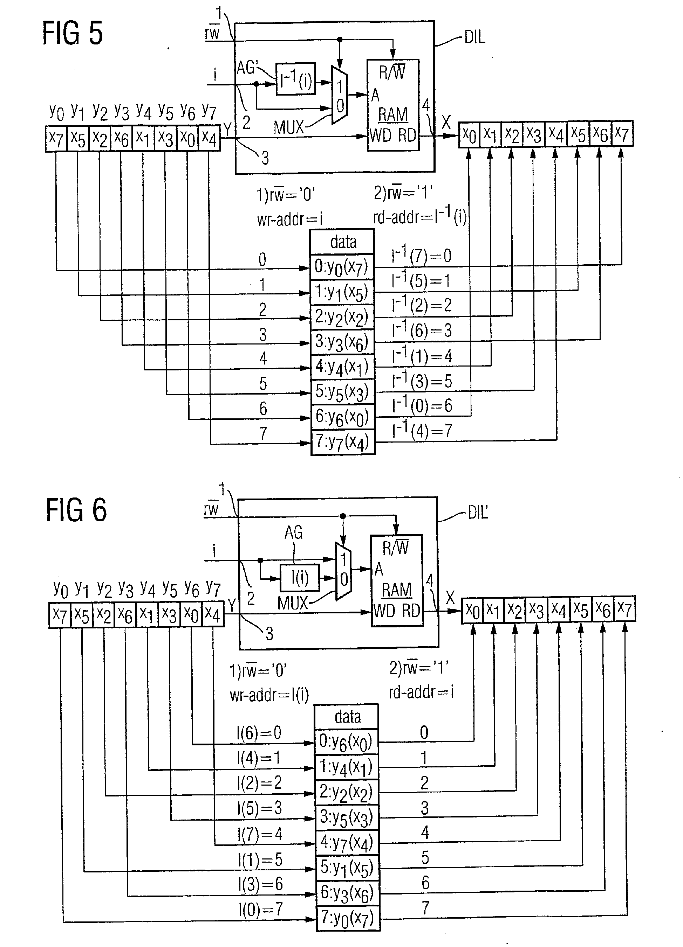

Da das Entschachteln der inverse Vorgang des Verschachtelns ist, kann der Entschachteler DIL (siehe Fig. 5) basierend auf der in Fig. 2 dargestellten Architektur des Verschachtelers IL aufgebaut werden. Der einzige Unterschied besteht darin, dass beim Lesen der Symbole die inverse Adressenfunktion I$^{-1}$(i) statt I(i) ausgeführt werden muss. Analog hierzu ist der in Fig. 6 dargestellte Entschachteler DIL' basierend auf der in Fig. 3 dargestellten Architektur des Verschachtelers IL' gebildet. Beim Schreiben der Symbole kommt hier anstelle der Funktion I$^{-1}$(i) die Funktion I(i) zur Anwendung. Die Entschachteler DIL und DIL' sind zwar nicht funktionstechnisch aber hinsichtlich ihrem logischen Eingangs-/Ausgangsverhalten äquivalent.

Die vorstehenden Ausführungen machen klar,

- dass das Verschachtelungs-Permutationsmuster **I** oder das inverse Verschachtelungs-Permutationsmuster **I$^{-1}$** in einem Entschachteler/Verschachteler als Folge von Lese- oder Schreibadressen für den Symbolspeicher eingesetzt werden, und
- dass nur eines dieser beiden Verschachtelungs-Permutationsmuster **I** oder **I$^{-1}$** berechnet werden muss, um sowohl einen Verschachteler als auch einen Entschachteler betreiben zu können. D.h., die Verschachtelung und die Entschachtelung einer Symbolfolge kann mit nur einem einzigen Adressgenerator AG oder alternativ AG' bewerkstelligt werden.

2. Turbo-Codierer und Turbo-Decodierer

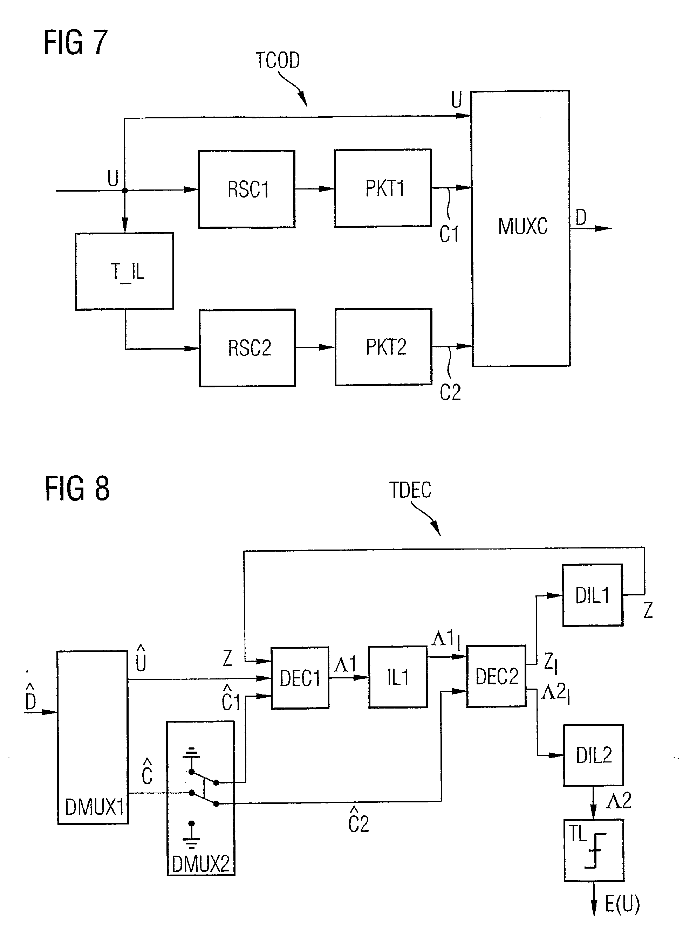

Anhand Fig. 7 wird beispielhaft der bekannte Aufbau eines Turbo-Codierers TCOD erläutert. Turbo-Codierer mit anderem Aufbau sind ebenfalls möglich und von der Erfindung umfasst.

Der hier dargestellte Turbo-Codierer TCOD weist einen Turbo-Verschachteler T_IL, zwei identische, rekursive, systematische Faltungscodierer RSC1 und RSC2, zwei optionale Punktierer PKT1 und PKT2 und einen Multiplexer MUXC auf. Das Eingabesignal ist eine zu codierende Bitsequenz U, bei der es sich beispielsweise um ein quellencodiertes Sprach- oder Videosignal handeln kann.

Der Turbo-Codierer TCOD erzeugt ein digitales Ausgabesignal D, das durch Multiplexen des Eingabesignals U (sogenanntes systematisches Signal), eines von RSC1 codierten und ggf. von PKT1 punktierten Signals C1 und eines von T_IL verschachtelten, von RSC2 codierten und ggf. von PKT2 punktierten Signals C2 erzeugt wird.

Der Turbo-Verschachteler T_IL kann gemäß den in den Fig. 2 und 3 dargestellten Verschachtelern realisiert sein.

Das fehlerschutzcodierte Datensignal D wird dann in geeigneter Weise auf einen Träger moduliert und über einen Übertragungskanal übertragen.

Die Decodierung eines Turbo-codierten Empfangssignals in einem Empfänger wird nachfolgend beispielhaft unter Bezugnahme auf den in Fig. 8 gezeigten, bekannten Turbo-Decodierer TDEC erläutert. Variationen dieses Aufbaus sind möglich und ebenfalls von der Erfindung umfasst.

Der Turbo-Decodierer TDEC umfaßt einen ersten und einen zweiten Demultiplexer DMUX1 und DMUX2, einen ersten und zweiten Faltungsdecodierer DEC1 und DEC2, einen Turbo-Verschachteler IL1, einen ersten und einen zweiten Turbo-Entschachteler DIL1 und DIL2 sowie eine Entscheidungslogik (Schwellenwertentscheider) TL.

Von einem Demodulator (nicht dargestellt) des Empfängers wird eine Symbolfolge $\hat{D}$ bereitgestellt, die die im Empfänger erzeugte Rekonstruktion der codierten Symbolfolge D ist. Zumeist besteht die Symbolfolge $\hat{D}$ aus Soft- Bit-Werten, welche zu jedem Bit der codierten Symbolfolge D eine Wahrscheinlichkeit für das Vorliegen einer 0 oder einer 1 dieses im Empfänger unbekannten Bits angeben.

Die bekannte Funktionsweise des in Fig. 8 gezeigten Turbo-Decodierers TDEC wird im folgenden kurz erläutert.

Der erste Demultiplexer DMUX1 spaltet die demodulierte Symbolfolge $\hat{D}$ in die demodulierte systematische Symbolfolge $\hat{U}$ (rekonstruierte Version des Eingabesignals U) und ein demoduliertes Redundanzsignal $\hat{C}$ auf. Letzteres wird von dem zweiten Demultiplexer DMUX2 in Abhängigkeit von der im Turbo-Codierer TCOD verwendeten Multiplexier- und Punktierungsvorschrift in die beiden entzerrten Redundanz-Teilsignale $\hat{C}1$ und $\hat{C}2$ (das sind die rekonstruierten Versionen der Redundanz-Teilsignale C1 und C2) aufgespalten.

Die beiden Faltungsdecodierer DEC1 und DEC2 können z.B. MAP-Symbolschätzer sein. Der erste Faltungsdecodierer DEC1 berechnet ausgehend von den Datensignalen $\hat{U}$ und $\hat{C}1$ und einem Rückkoppelsignal Z (sogenannte extrinsische Information) erste logarithmische Zuverlässigkeitsdaten $\Lambda1$ in Form von LLRs (Log-Likelihood Ratios).

Die ersten Zuverlässigkeitsdaten $\Lambda1$, die auch die systematischen Symbole der Symbolfolge $\hat{U}$ enthalten, werden von dem Turbo-Verschachteler IL1 verschachtelt und die verschachtelten Zuverlässigkeitsdaten $\Lambda1_I$ werden dem zweiten Faltungsdecodierer DEC2 zugeführt. Die Arbeitsweisen der Turbo-Verschachteler T_IL und IL1 sind identisch (jedoch verschachtelt T_IL einen Bitstrom und IL1 üblicherweise einen Symbolstrom mit Wortbreiten größer 1). Der zweite Faltungsdecodierer DEC2 berechnet aus den verschachtelten Zuverlässigkeitsdaten $\Lambda1_I$ und aus den rekonstruierten Redundanz-Teilsignaldaten $\hat{C}2$ ein verschachteltes Rückkoppelsignal $Z_I$ und verschachtelte zweite logarithmische Zuverlässigkeitsdaten $\Lambda2_I$, ebenfalls in Form von LLRs.

Das verschachtelte Rückkoppelsignal $Z_I$ wird von dem ersten Turbo-Entschachteler DIL1 entschachtelt und ergibt das Rückkoppelsignal Z.

Die dargestellte Rekursionsschleife wird mehrmals durchlaufen. Jedem Durchlauf liegen die demodulierten Symbole desselben Datenblocks zugrunde. Pro Durchlauf werden zwei Decodierschritte (in DEC1 und DEC2) durchgeführt. Die beim letzten Durchlauf erhaltenen verschachtelten zweiten Zuverlässigkeitsdaten $\Lambda2_I$ werden von dem zweiten Entschachteler DIL2 entschachtelt und als entschachtelte Zuverlässigkeitsdaten A2 der Entscheidungslogik TL zugeführt. Diese bestimmt daraufhin ein binäres Datensignal E(U), welches eine Sequenz von Schätzwerten für die Bits des Eingabesignals U ist.

Nach der Turbo-Decodierung eines Datenblocks und Ausgabe der entsprechenden Sequenz von Schätzwerten E(U) wird der nächste Datenblock Turbo-decodiert.

Wie an dem beispielhaft in Fig. 8 dargestellten Turbo-Decodierer TDEC ersichtlich, umfasst eine Turbo-Decodierung bei jedem Schleifendurchlauf eine Turbo-Verschachtelungsprozedur (IL1) und eine Turbo-Entschachtelungsprozedur (DIL1). Es werden hierfür die in den Fig. 2, 3 bzw. 5, 6 dargestellten Verschachteler oder Entschachtler eingesetzt.

3. Algorithmus eines Pseudo-Zufalls-Verschachtelers und Erzeugungsregel für ein Pseudo-Zufalls-Verschachtelungs-Permutationsmuster

Das einer Pseudo-Zufalls-Verschachtelung zugrundeliegende Prinzip ist folgendes:

- die nicht verschachtelte Symbolfolge wird nach einer ersten bestimmten Zuordnungsvorschrift (z.B. Zeile für Zeile) in eine Rechteckmatrix geschrieben; gebenenfalls frei bleibende Positionen in der Rechteckmatrix werden mit Füllzeichen aufgefüllt;
- die Rechteckmatrix wird einer Koordinatentransformation (Interzeilenpermutation; Intrazeilenpermutation) unterzogen;
- die transformierte Rechteckmatrix wird nach einer zweiten bestimmten Zuordnungsvorschrift (z.B. Spalte für Spalte) ausgelesen; Füllzeichen werden dabei verworfen.

Die Erfindung wird im folgenden anhand der im UMTS-Standard angegebenen Vorgaben für das Turbo-Verschachteln erläutert. Diese werden nun näher betrachtet.

Es werden die nachstehenden Definitionen verwendet:

K     Anzahl der Bits eines Blocks
R     Anzahl der Zeilen der Rechteckmatrix
C     Anzahl der Spalten der Rechteckmatrix
p     Primzahl
v     Primitive Wurzel, die der Primzahl p zugeordnet ist

s        Basissequenz **s**= (s (0), s (1), ..., s (p- 2) ) für die Intrazeilenpermutation
q        Sequenz **q**= (q (0), q (1), ..., q (R- 1) ) der minimalen Primzahlen
T        Interzeilen- Permutationsmuster **T**= (T (0), T (1), ..., T (R- 1) )
$W_i$      Intrazeilen- Permutationsmuster $W_i$= ($W_i$ (0), $W_i$ (1), ..., $W_i$ (C- 1) ) der i- ten Zeile
I        Verschachtelungs- Permutationsmuster **I**= (I (0), I (1), ..., I (K- 1) )
$I^{-1}$     inverses Verschachtelungs- Permutationsmuster $I^{-1}$= ($I^{-1}$ (0), $I^{-1}$ (1), ..., $I^{-1}$ (K- 1) )
i, j, k    Indizes von Sequenzen

3.1 Schritt 1: Definition der Rechteckmatrix (UMTS-Standard)

3.1.1 Definition der Anzahl R der Zeilen der Rechteckmatrix:

R=5,     falls 40≤K≤159
R=10,    falls 160≤K≤200 oder falls 481≤K≤530
R=20,    sonst [0.1]

Die Zeilen werden von oben nach unten beginnend mit 0 und endend mit R-1 durchgezählt.

3.1.2 Definition der Anzahl C der Spalten der Rechteckmatrix:

(i) Bestimme die Primzahl p:

  für 481≤K≤530: p=53 und C=p
  sonst: Suche die minimalen Primzahl p aus Tabelle 1, so dass K≤R×(p+1)

(ii) Bestimme die Anzahl der Spalten C:

  C=p-1 falls K≤R×(p-1)
  C=p falls R× (p- 1) <K≤R×p
  C=p+1 falls Rxp<K [0.2]

Die Spalten der Rechteckmatrix werden von links nach rechts beginnend mit 0 und endend mit C-1 durchgezählt. Die maximale Spaltenanzahl beträgt $C_{max}$=256.

Tabelle 1

| p | v | p | v | p | v | p | v | p | v |
|---|---|---|---|---|---|---|---|---|---|
| 7 | 3 | 47 | 5 | 101 | 2 | 157 | 5 | 223 | 3 |
| 11 | 2 | 53 | 2 | 103 | 5 | 163 | 2 | 227 | 2 |
| 13 | 2 | 59 | 2 | 107 | 2 | 167 | 5 | 229 | 6 |
| 17 | 3 | 61 | 2 | 109 | 6 | 173 | 2 | 233 | 3 |
| 19 | 2 | 67 | 2 | 113 | 3 | 179 | 2 | 239 | 7 |
| 23 | 5 | 71 | 7 | 127 | 3 | 181 | 2 | 241 | 7 |
| 29 | 2 | 73 | 5 | 131 | 2 | 191 | 19 | 251 | 6 |
| 31 | 3 | 79 | 3 | 137 | 3 | 193 | 5 | 257 | 3 |
| 37 | 2 | 83 | 2 | 139 | 2 | 197 | 2 |  |  |
| 41 | 6 | 89 | 3 | 149 | 2 | 199 | 3 |  |  |
| 43 | 3 | 97 | 5 | 151 | 6 | 211 | 2 |  |  |

3.2 Schritt 2: Einlesen der nicht verschachtelten Symbolfolge in die Rechteckmatrix und Auffüllen der Matrix mit Füllzeichen:

Die nicht verschachtelte Symbolfolge $x_0$, $x_1$, $x_3$, ..., $x_{K-1}$ wird Zeile für Zeile in die R×C Rechteckmatrix geschrieben. Das erste Symbol ist $x_0$ und wird in die 0- te Spalte der 0- ten Zeile geschrieben. Falls R×C>K, werden Füllzeichen in der Weise hinzugefügt, dass $x_k$=0 oder 1 für k=K, K+1, ..., R×C- 1.

3.3 Schritt 3: Definition der Koordinatentransformation in der Rechteckmatrix und Durchführung der Koordinatentransformation:

Die Schritte 3.3.1 bis 3.3.3 sind Vorbereitungsschritte, die Koordinatentransformation wird in den Schritten 3.3.4 (Interzeilenpermutation) und 3.3.5 (Intrazeilenpermutation) durchgeführt.
3.3.1 Wähle die rechts neben der Primzahl p angegebene primitive Wurzel v aus der Tabelle 1 aus. Primitive Wurzeln v weisen die Eigenschaft $v^p$=1 mod p auf, wobei $v^i$ mod p≠1 für alle ganzen Zahlen 0<i<p gilt.
3.3.2 Bestimme die erste Primzahl der Sequenz **q**= (q (0), q (1), ..., q (R- 1) ) zu $q_0$=1, und bestimme die Primzahlen $q_i$ derart, dass sie "letzte" Primzahlen sind, d.h. dass ggT (q (i), p- 1) =1, q (i) >6, und q (i) >q (i- 1) für jedes i=1, 2, ..., R- 1. Mit ggT ( , ) ist der größte gemeinsame Teiler bezeichnet.
3.3.3 Konstruiere die Basissequenz
s= (s (0), s (1), ..., s (p- 2) ) für die Intrazeilenpermutationen gemäß der folgenden Rekursion:

$$s(0)=1, \quad s(j)=(v \times s(j-1)) \bmod p, \quad j=1,2,\ldots,(p-2)$$

$$[0.3]$$

3.3.4 Führe die Interzeilenpermutation der Rechteckmatrix basierend auf dem Interzeilen- Permutationsmuster **T**= (T (0), T (1), ..., T (R- 1) ) durch, wobei **T** (i) die ursprüngliche Zeilenposition der **i**- ten permutierten Zeile ist. Als Interzeilen- Permutationsmustern **T** ist dasjenige von vier in Tabelle 2 definierten Mustern heranzuziehen, welches in Abhängigkeit von der Blockgröße K ausgewählt wird.

Tabelle 2

| Blockgröße K | Zeilen-Anzahl R | Interzeilen-Permutationsmuster **T** (T(0),T(1),...,T(R-1)) |
|---|---|---|
| (40≤K≤159) | 5 | (4, 3, 2, 1, 0) |
| (160≤K≤200) oder (481≤K≤530) | 10 | (9, 8, 7, 6, 5, 4, 3, 2, 1, 0) |
| (2281≤K≤2480) oder (3161≤K≤3210) | 20 | (19, 9, 14, 4, 0, 2, 5, 7, 12, 18, 16, 13, 17, 15, 3, 1, 6, 11, 8, 10) |
| K = andere Werte | 20 | (19, 9, 14, 4, 0, 2, 5, 7, 12, 18, 10, 8, 13, 17, 3, 1, 16, 6, 15, 11) |

3.3.5 Führe die Intrazeilenpermutation an der i- ten (i=0, 1, ..., R- 1) interzeilen- permutierten Zeile basierend auf dem Intrazeilen- Permutationsmuster $W_i$= (Wi (0), $W_i$ (1), ..., $W_i$ (C- 1) ) in folgender Weise durch:

$$\text{Falls } (C=p), \text{ dann}$$
$$W_i(j) = s(((j \times q(i)) \bmod(p-1))), \quad j=0,1,\ldots,(p-2), \text{ und}$$
$$W_i(p-1)=0, \qquad\qquad [0.4]$$

$$\text{Falls } (C=p-1), \text{ dann}$$
$$W_i(j) = s(((j \times q(i)) \bmod(p-1)))-1, \quad j=0,1,\ldots,(p-2)$$
$$[0.5]$$

```
Falls (C=p+1), dann
Wᵢ(j) = s(((j × q(i)) mod(p − 1))),   j=0,1,...,(p-2), und
Wᵢ(p-1)=0, Wᵢ(p)=p,                              [0.6]
```

ferner:

```
    falls (K=(R×C)), dann
Wₒ(0)=p,   Wₒ(p)=1                              [0.7]
```

wobei $W_i(j)$ die ursprüngliche Spaltenposition des j-ten permutierten Bits der i-ten permutierten Zeile ist.

3.4 Schritt 4: Ausgabe der verschachtelten Symbolfolge und Entfernen der Füllzeichen

Nach Durchführung der Intrazeilen- und Interzeilenpermutationen werden die Symbole aus der transformierten Rechteckmatrix Spalte für Spalte ausgelesen. Es wird mit dem Symbol in der Zeile 0 der Spalte 0 begonnen und mit dem Symbol in der Zeile R-1 der Spalte C-1 aufgehört. Die Ausgabe-Symbolfolge wird durch Entfernen der Füllzeichen, welche der nicht verschachtelten Symbolfolge vor den Intrazeilen- und Interzeilenpermutationen hinzugefügt wurden, beschnitten. Diese sind in der Ausgabe-Symbolfolge "verstreut" angeordnet, d.h. sie müssen zunächst identifiziert werden. Nach dem Entfernen der Füllzeichen liegt die verschachtelte Symbolfolge vor.

Das Verschachtelungs- Permutationsmuster I= (I (0), I (1), ..., I (K- 1) ) kann wie bereits erläutert dadurch erzeugt werden, dass anstelle der Symbole die Indizes der Symbole verschachtelt werden, d.h. dass die ganzen Zahlen k=0, 1, 2, ..., K- 1 in die Rechteckmatrix eingelesen werden, sofern K<R×C die Rechteckmatrix mit weiteren (ungültigen) Indizes K, K+1, ..., R×C- 1 aufgefüllt wird, die Rechteckmatrix transformiert wird, die Indizes ausgelesen werden und die ungültigen Indizes (Test: Index>K- 1?) entfernt werden.

Die obigen Ausführungen machen klar, dass I eine Folge von umgeordneten Zeitschrittindizees ist. Gemäß den Erläuterungen zu den Fig. 1 bis 6 kann man I auch als eine Folge von Adressen auffassen, nämlich den Adressen für den Zugriff auf den Symbolspeicher, in welchem die zu verschachtelnden (oder zu entschachtelnden) Symbole gespeichert sind.

Im Folgenden wird aus Gründern der besseren Lesbarkeit die Notation geändert: Indizes der nicht verschachtelten Symbolfolge X und der verschachtelten Symbolfolge Y werden in Klammern gesetzt, d.h.

$$X: x_0, x_1, ..., x_{K-1} \Rightarrow \mathbf{x} = (x(0), x(1), ..., x(K-1))$$

$$Y: y_0, y_1, ..., y_{K-1} \Rightarrow \mathbf{y} = (y(0), y(1), ..., y(K-1))$$

Beispiel 1: UMTS-Verschachtelung für K=43: Verschachtelungs-Permutationsmuster I

Die UMTS-Verschachtelung wird anhand eines Beispiels für K=43 erläutert. Gemäß den oben beschriebenen Schritten ergeben sich die folgenden Parameter:

```
R=5, p=11, v=2, C=10,
q=(1,7,11,13,17), T=(4,3,2,1,0), s=(1,2,4,8,5,10,9,7,3,6)
```

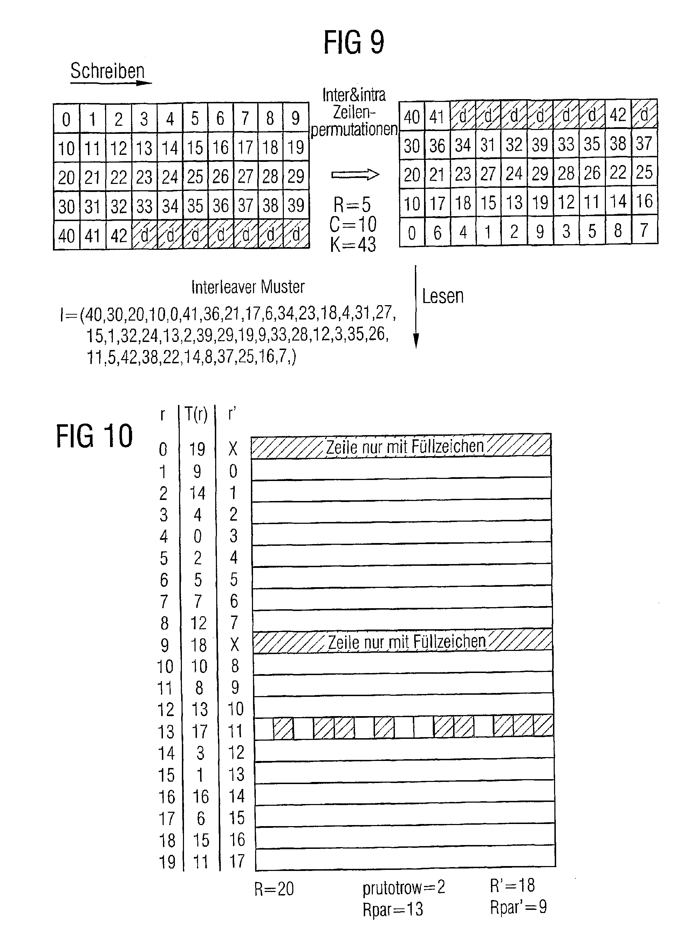

Wie bereits erwähnt, ergibt sich das Verschachtelungs- Permutationsmuster I= (I (0), I (1), ..., I (K- 1) ), indem zunächst die ganzen Zahlen 0, 1, ..., 42 Zeile für Zeile in die R×C Rechteckmatrix beginnend in der obersten Zeile eingefügt werden und Füllzeichen d ("dummy symbols") am Ende des Füllprozesses in die Matrix eingefügt werden. Dies ist im linken Teil der Fig. 9 dargestellt. Nach der Durchführung der Inter- und Intrazeilenpermutationen ergibt sich die im rechten Teil der Fig. 9 gezeigte Matrix identischer Dimension. Das in Fig. 9 angegebene Verschachtelungs-Permutationsmuster I ergibt sich dann durch spaltenweises Auslesen der Matrix beginnend mit der linken Spalte. Dabei müssen die zuvor eingefügten Füllzeichen d aus dem ausgelesenen Verschachtelungsmuster wieder entfernt werden.

4. Implementierung des Turbo-Verschachtelers/-Entschachtelers

Das Speichern des in der vorstehend beschriebenen Weise erzeugten Verschachtelungs-Permutationsmusters würde einen Speicherbereich von 5114 Datenwörtern der Breite von 13 Bit, d.h. eine Speichergröße von etwa 65 kBit erfordern. Der in den Fig. 2, 3, 5 bzw. 6 dargestellte Adressgenerator AG, AG' würde in diesem Fall den Speicher zum Speichern des Verschachtelungs-Permutationsmusters enthalten. Dies ist aufgrund des hohen Speicherplatzbedarfs eine ungünstige Lösung. Eine alternative Möglichkeit besteht darin, den k-ten Index (Adresse) I(k) des Verschachtelungs-Permutationsmusters immer genau dann zu berechnen, wenn er von der nachfolgenden Einheit während des Decodierprozesses (bzw. Codierprozesses) benötigt wird.

Für den Fall, dass die Rechteckmatrix keine Füllzeichen enthält - dieser Fall liegt für $K = R \times C$ vor - ist diese "on-the-fly" Berechnung der Adresse I(k) sehr einfach. Sie folgt direkt aus der Schreib-Zuordnungsvorschrift, der Matrix-Transformationsvorschrift und der Lese-Zuordnungsvorschrift.

Zunächst werden die Spaltenkoordinate c und die Zeilenkoordinate r der Rechteckmatrix berechnet:

$$c = k \ \text{div} \ R \qquad\qquad [0.8]$$

$$r = k \ \text{mod} \ R \qquad\qquad [0.9]$$

Die Adresse I(k) ergibt sich nach

$$I(k) = T(r) \times C + W_r(c). \qquad\qquad [0.10]$$

Dabei beinhaltet $W_r(c)$ die Intrazeilenpermutation der r-ten permutierten Zeile auf der Basis von s und q(r).

Sofern die Rechteckmatrix Füllzeichen enthält, gestaltet sich die Berechnung der Adresse I(k) schwieriger.

Eine Möglichkeit zur Identifizierung von Adressen von Füllzeichen aus dem gemäß Gleichung [0.10] berechneten Verschachtelungs-Permutationsmuster besteht wie bereits erwähnt darin, die Bedingung I(k)<K zu testen. Falls diese Bedingung erfüllt ist, ist die berechnete Adresse eine gültige Adresse und das zugehörige Symbol kann aus der bzw. in die entsprechende Position im Symbolspeicher RAM des Verschachtelers/Entschachtelers gelesen bzw. geschrieben werden. Falls die Bedingung nicht erfüllt ist, entspricht die berechnete Adresse einer ungültigen (mit einem Füllzeichen aufgefüllten) Position, so dass kein Schreib- oder Lesezugriff ausgeführt werden kann. Die ungültige Adresse muss verworfen werden und es wird für den nächsten Zeitschritt k+1 die Adress-Berechnung I(k+1) gemäß der Gleichung [0.10] und der obige Bedingungstest vorgenommen.

Durch das Verwerfen von ungültigen Adressen entstehen Lücken in dem Adress-Berechnungsfluss. Dadurch geht die Synchronität von Zeitschritten k und berechneten (gültigen) Adressen I(k) verloren. Bei einer Lücke kann ein entschachteltes Symbol erst mit einer Zeitverzögerung bereitgestellt werden. Dies schafft Probleme bei der Weiterverarbeitung der entschachtelten Symbole und soll durch die Erfindung vermieden werden.

Fig. 10 zeigt für R=20, C=15 die transformierte Rechteckmatrix. Die oberste Zeile r=0 und die Zeile r=9 sind ausschließlich mit Füllzeichen belegt. Die Zeile r=13 ist teilweise mit Füllzeichen belegt. Im UMTS-Standard können maximal zwei vollständig mit Füllzeichen belegte Zeilen auftreten.

Die vollständig mit Füllzeichen belegten Zeilen werden durch eine Umnummerierung der Zeilenkoordinate r in r' berücksichtigt: Die Zeilenkoordinate r' nummeriert lediglich die nicht vollständig mit Füllzeichen belegten Zeilen durch.

Zur Berücksichtigung der teilweise mit Füllzeichen belegten Zeile r=13 wird eine erste Tabelle **prucol** der Länge C definiert. Die erste Tabelle **prucol** enthält Information bezüglich der Position der Füllzeichen in der teilweise mit Füllzeichen belegten Zeile. Die erste Tabelle **prucol**= (prucol (0), ..., prucol (C- 1) ) ist durch die folgende Gleichung definiert:

$$\text{prucol}(c) = \begin{cases} 1 \ \text{falls ein Füllzeichen bei der Spaltenkoordinate c auftritt} \\ \\ 0 \quad \text{sonst} \end{cases} \qquad [0.11]$$

Ferner wird eine zweite Tabelle **pruleftcol** der Länge C definiert, deren c-ter Eintrag die Gesamtanzahl von Füllzeichen angibt, die links von der Position c (einschließlich der Position c) angeordnet sind:

**pruleftcol**= (pruleftcol (0), ..., pruleftcol (C- 1) ) mit

$$\text{pruleftcol}(c) = \sum_{i=0}^{c} \text{prucol}(i) \qquad\qquad [0.12]$$

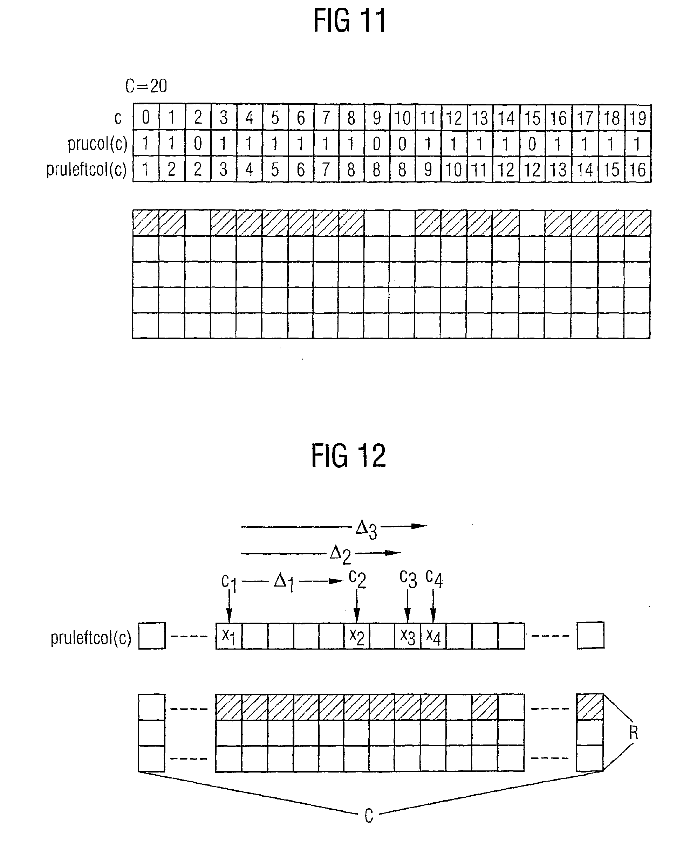

Fig. 11 zeigt für C=20, R=5 die Einträge der ersten Tabelle **prucol** und der zweiten Tabelle **pruleftcol,** sowie im unteren Teil der Fig. 11 die zugehörige transformierte Rechteckmatrix.

Zunächst wird der (einfachere) Fall betrachtet, dass die teilweise mit Füllzeichen belegte Zeile die oberste Zeile der transformierten Rechteckmatrix ist. Nachdem zu dem Zeitschritt k eine Anfangs-Spaltenkoordinate $c_1$=k div R gemäß Gleichung [0.8] berechnet ist, wird in der zweiten Tabelle **pruleftcol** die Anzahl der Füllzeichen nachgeschlagen, die in den Spalten links von der Anfangs-Spaltenkoordinate $c_1$ einschließlich der Spalte $c_1$ übersprungen wurden. Es ergibt sich $x_1$=pruleftcol ($c_1$). Die Anzahl $x_1$ kann größer als die Zeilenanzahl sein, so dass es erforderlich wird, die Anzahl der Spalten $\Delta_1$=$x_1$ div R zu berechnen, die zu der Anfangs-Spaltenkoordinate $c_1$ hinzuzufügen sind. Ein nochmaliges Nachschlagen in der zweiten Tabelle **pruleftcol** bei der Position $c_2$=$c_1$+$\Delta_1$ ergibt die Gesamtanzahl von Füllzeichen $x_2$=pruleftcol ($c_2$) vom Zeilenanfang bis einschließlich zu der Spaltenkoordinate $c_2$. Falls $\Delta_2$=$x_2$ div R>$\Delta_1$, muss anhand der zweiten Tabelle **pruleftcol** nochmals überprüft werden, ob "neue" Füllzeichen beim Erhöhen des Spaltenkoordinaten-wertes $c_3$=$c_1$+$\Delta_2$ aufgetreten sind. Dieser Prozess wird solange fortgeführt, bis $\Delta_n$=$\Delta_{n-1}$ festgestellt wird. Das Nachschlagen der End-Spaltenkoordinate $c_n$ entspricht dann der Gesamtanzahl von Füllzeichen, die bezüglich der Anfangs-Spaltenkoordinate $c_1$ in der "Vergangenheit" und in der "Zukunft" zu berücksichtigen sind. Fig. 12 veranschaulicht anhand eines Beispiels R=3 und $x_1$=17 die oben beschriebenen Zugriffe auf die zweite Tabelle **pruleftcol**. Der Wert $x_4$ entspricht der Gesamtanzahl der Füllzeichen, die bezüglich der Start-Spaltenkoordinate $c_1$ zu berücksichtigen sind.

Nach der Ermittlung von x=$x_n$ ergibt eine abschließende Division-Modulo-Operation bezüglich R den durch die Füllzeichen hervorgerufenen Spalten- und Zeilen-Offset. Zuletzt kann noch ein Nachschlagen in der ersten Tabelle **prucol** erforderlich sein, nämlich sofern die Summe der Zeilenkoordinate r=k mod R (siehe Gleichung [0.9]) und des Zeilen-Offsets x mod R größer als R ist.

Für den UMTS- Standard 3GPP 25.212 lässt sich zeigen, dass niemals mehr als 3 Zugriffe auf die zweite Tabelle **pruleftcol** erforderlich sind. Für andere Verschachtelungs- Erzeugungsregeln, welche eine Inter- und Intrazeilenpermutation benutzen, ist ebenfalls eine endliche Anzahl von Zugriffen ausreichend. Aufgrund dieser Konvergenz kann das beschriebene Verfahren auch für andere Pseudo- Zufalls- Verschachtelungs- Erzeugungsregeln eingesetzt werden.

Bis jetzt wurde angenommen, dass keine vollständig mit Füllzeichen belegten Zeilen existieren. Wie bereits erwähnt, ist dies nicht immer der Fall. Der oben beschriebene Algorithmus zum Entfernen von Füllzeichen kann jedoch in einfacher Weise an den Fall einer Rechteckmatrix, die vollständig mit Füllzeichen belegte Zeilen aufweist, angepasst werden. Zu diesem Zweck werden die folgenden, aus Fig. 10 ersichtlichen Variablen definiert:

- prutotrow, ($0 \leq$ prutotrow $\leq 2$) : Gesamtanzahl der vollständig mit Füllzeichen belegten Zeilen.

- Rpar, ($0 \leq$ Rpar $\leq 19$): Zeilenkoordinate der teilweise mit Füllzeichen gefüllten Zeile nach der Interzeilenpermutation.

- Rpar', ($0 \leq$ Rpar' $\leq 19$) : Zeilenkoordinate der zweiten (d.h. der nicht oben liegenden) vollständig mit Füllzeichen belegten Zeile nach der Interzeilenpermutation.

- R'=R-prutotrow, ($0 \leq$ R' $\leq 19$): Anzahl der Zeilen, die nicht vollständig mit Füllzeichen belegt sind.

Es wird darauf hingewiesen, dass prutotrow=R- [K/C] nur für R=20 ungleich 0 ist. Gemäß Fig. 10 ist für R=5 wie auch für R=10 die teilweise mit Füllzeichen belegte Zeile immer die oberste Zeile.

Ferner ist der Fig. 10 zu entnehmen, dass Rpar=$T^{-1}$ (R- 1- prutotrow) gilt, d.h. Rpar entspricht der Position der ganzen Zahl R- 1- prutotrow in der Sequenz **T**.

Des weiteren ist aus Fig. 10 ersichtlich, dass Rpar' die Zeilenkoordinate ist, auf welche die 18- te ursprüngliche Zeile abgebildet wird. Der Parameter Rpar' wird nur benötigt, wenn prutotrow=2 ist. Es gilt Rpar'=$T^{-1}$ (R- prutotrow) . D.h., Rpar' entspricht der Position der Zahl R- prutotrow=20- 2=18 in der Sequenz **T**. Somit gilt Rpar'=9.

Für die Bestimmung der Anfangs-Spalten- und Zeilenkoordinaten nach den Gleichungen [0.8] und [0.9] wie auch für die Prozedur zum Entfernen der Füllzeichen werden die vollständig mit Füllzeichen belegten Zeilen ignoriert, d.h. die Divisions- und Modulo-Operationen werden hinsichtlich R' und nicht hinsichtlich R durchgeführt (in Fig. 10 gilt R'=18 und R=20). Die auf diese Weise erhaltenen Zeilenkoordinaten beziehen sich somit auf die r'-Achse.

4.1 Erstes Ausführungsbeispiel: Adresserzeugung von I(k)

Im Folgenden wird ein erstes Ausführungsbeispiel des Gesamtalgorithmus für die Bestimmung der k-ten Adresse I(k) des Verschachtelungs-Permutationsmusters I erläutert. Zu diesem Zweck werden die beiden folgenden Funktionen definiert, die die im Schritt 3.3.5 des UMTS-Standards definierten Ausnahmen bei der Durchführung der Intrazeilenpermutation beinhalten:

$$f_{col}(c,r,p,K,R,C) = \begin{cases} c-1 & \text{if } C = (p-1) \\ 0 & \text{if } C \neq (p-1), c = (p-1) \\ 1 & \text{if } C = (p+1), c = p, K = R \times C, r = 0 \\ p & \text{if } (C = (p+1), c = p, (K \neq R \times C \text{ or } r \neq 0)) \\ & \quad \text{or } (C = (p+1), c = 0, K = R \times C, r = 0) \\ c & \text{else} \end{cases} \qquad [0.13]$$

$$f_{init}(c,p,C) = \begin{cases} c-1 & \text{if } C = (p-1) \\ 0 & \text{if } C \neq (p-1), c = (p-1) \\ p & \text{if } C = (p+1), c = p \\ c & \text{else} \end{cases} \qquad [0.14]$$

Die Funktion $f_{init}$ ( ) ist ein Spezialfall der Funktion $f_{col}$ ( ), da sie allein die Spalten-Ausnahmebestimmungen für die teilweise mit Füllzeichen belegten Zeilen betrifft. Im Unterschied zur Funktion $f_{col}$ ( ), die während der eigentlichen Adress-Berechnung verwendet wird, wird die Funktion $f_{init}$ ( ) lediglich in der Initialisierungsphase für die Berechnung der ersten und zweiten Tabellen **prucol** und **pruleftcol** benötigt.

4.1.1 Algorithmus zur Bestimmung der Tabellen **prucol** und **pruleftcol**

Vor der Berechnung der Tabellen **prucol** und **pruleftcol** muss die Basissequenz **s** für die Intrazeilenpermutation bekannt sein. Ferner müssen die Werte K, C, Rpar, R', p und die Sequenz **q** vorliegen.
Die ersten und zweiten Tabellen **prucol** und **pruleftcol** können nach dem folgenden Algorithmus berechnet werden.

```
base = (R'-1) * C
j = sum = 0
while (j < C) {
        c  = s[(j*q[Rpar]) mod (p-1)]
        c' = f_init(c,p,C)

        if (base + c' < K)   t = 0
        else   t = 1
        sum = sum + t
        prucol[j] = t
        pruleftcol[j] = sum

        j = j + 1
}
```

Da die maximale Anzahl von Spalten $C_{max}$ = 256 ist, werden maximal 256 Systemzyklen für die Berechnung der beiden Tabellen benötigt. Weitere 256 Systemzyklen werden für die Bestimmung der Basissequenz s gemäß Gleichung [0.3] benötigt.

4.1.2 Algorithmus zur Bestimmung der Adresse I(k)

Bei gegebenem Index (Zeitschritt) k wird die Adresse I(k) des Verschachtelungs-Permutationsmusters nach dem folgenden Algorithmus berechnet:

```
Rpar_ = Rpar - prutotrow
Rpar'_ = Rpar' - prutotrow
c1 = k div R'   /* ignore totally pruned rows */
r1 = k mod R'   /* ignore totally pruned rows */
------------------------------------------------------------
h1 = c1 + (pruleftcol[c1] div R')
h2 = c1 + (pruleftcol[h1] div R')
```

```
x = pruelftcol[h2]


c2 = x div R'
r2 = x mod R'
r3 = r1 + r2
---------------------------------------------------------------------
/* the following part corresponds to eq. [0.15] for input c =
c3, r = r3 */
if ( r3 >= R'){
        c4 = c3 + 1
        r4 = r3 - R'
        if ( r4 >= Rpar_ ) r4 = r4 + prucol[c3]
}
else{
        if ( Rpar_ > 0 ) and ( r3 <= Rpar_) )
            r4 = r3 - prucol[c3]
        }
}
/* now go back to original numbering of rows */
/* the following part corresponds to eq. [0.16] for input r =
r4*/
if ( prutotrow = 2 ){
        if ( r4 <= Rpar'_ ) r5 = r4 + 1
        else r5 = r4 + 2
}
else r5 = r4 + prutotrow


/* inter-, intra-row permutations and column exception hand-
ling */


r6 = T[r5]
c5 = s[(c4*q[r5]) mod (p-1)]
c6 = f_col(c5,r5,p,K,R,C)


/* matrix translation */


kout = r6*C + c6            /* I(k) = kout */
```

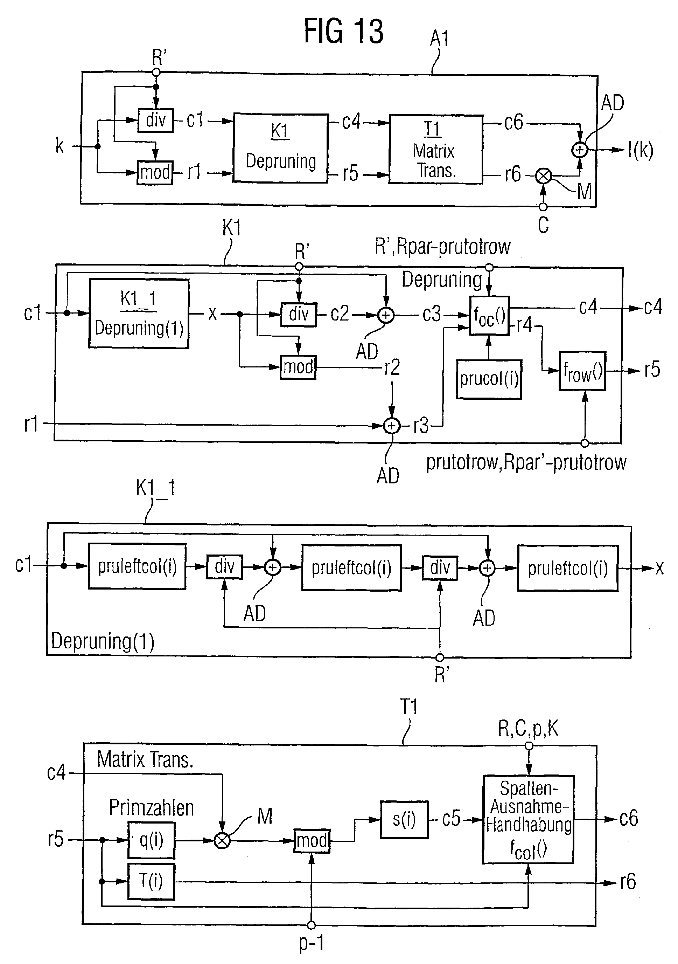

Der Algorithmus (Bezugszeichen A1) ist in der Fig. 13 veranschaulicht. Der Algorithmus A1 besteht in der Berechnung der Adresse I (k) aus k. Wie bereits erläutert und im oberen Teil der Fig. 13 veranschaulicht, erfolgt dies durch eine Ermittlung eines Koordinatenpaares (c1, r1) für die Rechteckmatrix, einer Korrektur des Koordinatenpaares durch einen Korrekturalgorithmus K1 (Depruning), welcher ein korrigiertes Koordinatenpaar (c4, r5) liefert, der Transformation T1 dieses korrigierten Koordinatenpaares (c4, r5) in ein transformiertes Koordinatenpaar (c6, r6) und der Berechnung der Adresse I (k) aus dem transformierten Koordinatenpaar (c6, r6) . In Fig. 13 ist mit div die Quotientenbildung, mit mod die Modulo- Operation, mit AD eine Addition und mit M eine Multiplikation bezeichnet.

Der Algorithmus K1 für die Berechnung des korrigierten Koordinatenpaares (c4,r5) umfasst einen Sub-Korrekturalgorithmus K1_1 ("Depruning (1)"), welcher aus der Anfangs-Spaltenkoordinate c1 den Wert x ermittelt, und den restlichen Korrekturalgorithmus, welcher bereits vorstehend beschrieben wurde. Zur besseren Lesbarkeit sind in Fig. 13 die folgenden 2-wertigen Funktionen eingeführt:

$$f_{oc}(c,r,R',Rpar\_) = \begin{cases} (c+1, r+R') & \text{if } r \geq R', r < Rpar\_ + R' \\ (c+1, r-R' + prucol(c+1)) & \text{if } r \geq R', r \geq Rpar\_ + R' \\ (c+1, r-prucol(c)) & \text{if } r < R', Rpar\_ > 0, r \leq Rpar\_ \\ (c, r) & \text{else} \end{cases}$$

$$[0.15]$$

$$f_{row}(r, prutotrow, Rpar'\_) = \begin{cases} r+1 & \text{if } prutotrow = 2, r \leq Rpar'\_ \\ r+2 & \text{if } prutotrow = 2, r > Rpar'\_ \\ r + prutotrow & \text{else} \end{cases} \qquad [0.16]$$

Die Funktion $f_{oc}$ ( ) übernimmt die Aufgabe einer Überlaufsteuerung, sofern der Wert nach der zweiten Modulo-Operation größer als R' wird, und korrigiert das Koordinatenpaar (c3,r3), sofern die teilweise mit Füllzeichen belegte Zeile nicht die oberste Zeile ist.

Die Funktion $f_{row}$ ( ) nummeriert die Zeilenkoordinaten um, sofern Zeilen vorhanden sind, die vollständig mit Füllzeichen belegt sind.

Ein gewisser Nachteil des erläuterten Algorithmus A1 besteht in dem Sub-Korrekturalgorithmus K1_1, und zwar deshalb, weil dieser einen mehrfachen (bei UMTS: 3-fachen) Speicherzugriff zu einem Datenspeicher, der die zweite Tabelle **pruleftcol** enthält, umfasst. Sofern die Adresse I(k) innerhalb eines Systemzyklus berechnet werden soll, müssen 3 Datenspeicher vorgesehen sein, welche jeweils die zweite Tabelle **pruleftcol** enthalten. In der dritten Darstellung von oben in Fig. 13 sind die (maximal) drei möglichen Speicherzugriffe auf den die zweite Tabelle **pruleftcol** speichernden Datenspeicher dargestellt.

In der untersten Darstellung in Fig. 13 ist der bereits erläuterte Algorithmus T1 für die Matrix-Transformation veranschaulicht.

Das im folgenden beschriebene zweite Ausführungsbeispiel vermeidet den oben angegebenen Nachteil des Sub-Korrekturalgorithmus K1 I.

4.2 Zweites Ausführungsbeispiel: Adresserzeugung von I(k)

Das mehrfache Nachschlagen eines Tabelleneintrags in der zweiten Tabelle **pruleftcol** beruht darauf, dass die Anzahl der Füllzeichen den Wert R' übertreffen kann, da in diesem Fall die Anzahl der Füllzeichen ermittelt werden muss, die bei der dann erforderlichen Erhöhung der Spaltenkoordinate entfernt werden müssen. Um dieses mehrfache Nachschlagen in der zweiten Tabelle **pruleftcol** zu vermeiden, liegt dem zweiten Ausführungsbeispiel die Idee zugrunde, in einer dritten Tabelle **prutotcol** = (prutotcol (0), ..., prutotcol (C- 1) )

so viel Information zur Verfügung zu stellen, dass ein einziges Nachschlagen in dieser Tabelle ausreichend ist. Hierfür muss der c-te Eintrag prutotcol(c) sowohl eine Information über die Anzahl der Füllzeichen-Belegungen in der "Vergangenheit" als auch in der "Zukunft" in Bezug auf die Spaltenkoordinate c umfassen.

4.2.1 Algorithmus zur Bestimmung der ersten Tabelle **prucol** und der dritten Tabelle **prutotcol**

Bei dem zweiten Ausführungsbeispiel wird die erste Tabelle **prucol** und die dritte Tabelle **prutotcol** nach dem folgenden Algorithmus berechnet. Wiederum muss die Basissequenz **s** für die Intrazeilenpermutation bekannt sein und die Werte K, C, Rpar, R', p sowie die Sequenz **q** müssen vorliegen.

```
base = (R'-1) * C
i = j = sum = acc = 0

while (j < C){
    c = s[(j*q[Rpar]) mod (p-1)]
    c' = finit(c,p,c)

    if ( base + c' < K) t = 0
    else t = 1

    prucol[j] = t

    sum = sum + t
    acc = acc + t

    if ( acc >= R' ) acc = 0
    else {
        prutotcol[i] = sum

        i = i + 1
    }
    j = j + 1
}
```

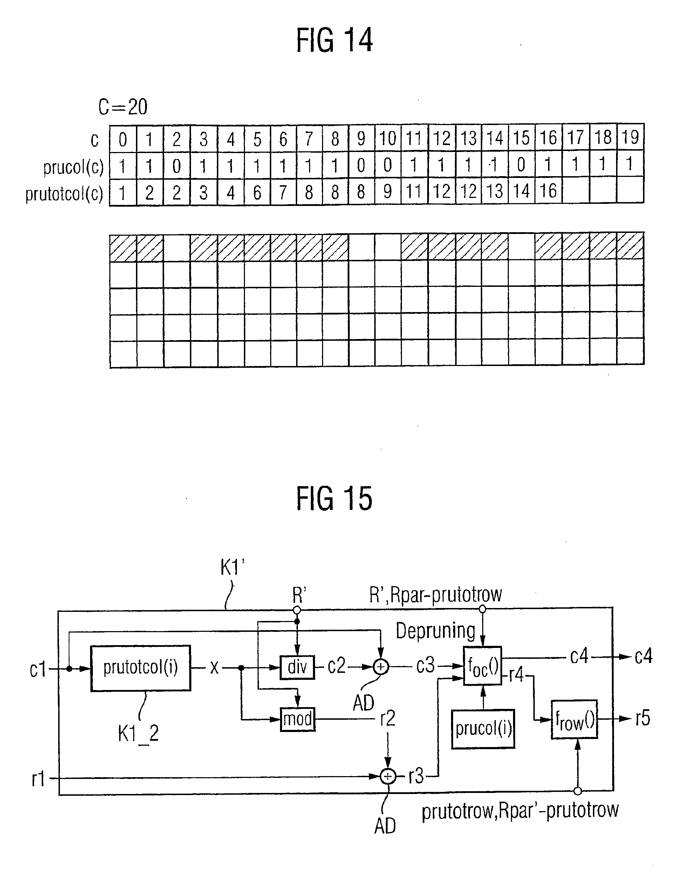

Immer wenn die Variable sum durch R' teilbar wäre, wird die nachfolgende Spaltenkoordinate abgewartet, bevor die Wertezuweisung für die Variable prutotcol erfolgt. Die Fig. 14 zeigt im oberen Teil für R=5, C=20 die Einträge der ersten Tabelle **prucol** und der dritten Tabelle **prutotcol**. Im unteren Teil der Fig. 14 ist die zugehörige transformierte Rechteckmatrix dargestellt, welche in der obersten Zeile eine teilweise mit Füllzeichen aufgefüllte Zeile aufweist.

4.2.2 Algorithmus zur Bestimmung der Adresse I(k)

Der Algorithmus für die Berechnung der Adresse I(k) bezüglich des zweiten Ausführungsbeispiels unterscheidet sich von dem zum ersten Ausführungsbeispiel in 4.1.2 angegebenen Algorithmus zur Berechnung der Adresse I(k) lediglich dadurch, dass in dem in 4.1.2 angegebenen Algorithmus der zwischen den gestrichelten Linien stehende Teil durch den folgenden Algorithmusteil ersetzt wird:

```
- - - - - - - - - - - - - - - - - - - - - - - - - - - - - - - - - - - - - - - - - - - - - - -
x  = prutotcol[c1]
c2 = x div R'
r2 = x mod R'
c3 = c1 + c2
r3 = r1 + r2
- - - - - - - - - - - - - - - - - - - - - - - - - - - - - - - - - - - - - - - - - - - - - - -
```

Fig. 15 veranschaulicht den Korrekturalgorithmus K1' gemäß dem zweiten Ausführungsbeispiel. Der einzige Unterschied zum Korrekturalgorithmus K1 gemäß dem ersten Ausführungsbeispiel besteht darin, dass der Sub-Korrekturalgorithmus K1_1 durch den Sub-Korrekturalgorithmus K1_2 ersetzt ist. Der Sub-Korrekturalgorithmus K1_2 wird durch ein einmaliges Nachschlagen in der dritten Tabelle **prutotcol** realisiert. Da ein einmaliges Nachschlagen in dieser Tabelle ausreichend ist, reicht ein einziger Datenspeicher für die dritte Tabelle **prutotcol** aus, um zu gewährleisten, dass die Berechnung der Adresse I(k) innerhalb eines Systemzyklus abgeschlossen ist.

Für beide Ausführungsbeispiele gilt, dass die erste und zweite Tabelle (erstes Ausführungsbeispiel) bzw. die erste und dritte Tabelle (zweites Ausführungsbeispiel) in der Initialisierungsphase berechnet werden können. Für die Berechnung der aktuellen Adresse I(k) muss somit lediglich in den im voraus berechneten Tabellen nachgeschlagen werden.

Im Folgenden wir die Umsetzung der Algorithmen nach dem ersten und dem zweiten Ausführungsbeispiel in eine Schaltung in beispielhafter Weise erläutert:

Die Schaltung umfasst einen DSP sowie ein mit dem DSP in Verbindung stehendes Hardware-Modul. Das Hardware-Modul ist im vorliegenden Beispiel durch eine Turbo-Decoder-Hardware einschließlich der Verschachteler/Entschachteler realisiert. Nach dem Erhalt einer Angabe über die Blocklänge K werden die Vorbereitungsschritte 3.1.1 und 3.1.2 (Bestimmen von R und C der Rechteckmatrix) sowie 3.3.1 und 3.3.2 (Bestimmen von v und **q**) in Firmware, d.h. mittels des DSP, durchgeführt. Dabei werden die folgenden Parameter berechnet und der Turbo-Decoder-Hardware zur Verfügung gestellt:

- RowSelect (2 Bit): Zeiger auf eines der 4 möglichen Interzeilen-Permutationsmuster nach Tabelle 2
- Primzahl p (9 Bit)
- Primitive Wurzel v (5 Bit)
- Anzahl der Spalten C (9 Bit)
- Primzahl- Sequenz **q**= (q (0), ..., q (R- 1) ) (20*7 Bit)
- Anzahl der vollständig mit Füllzeichen versehenen Zeilen prutotrow (2 Bit)

Zu diesem Zweck muss der Inhalt der Tabelle 1 in einem für den DSP verfügbaren Speicher abgelegt sein.

Der Inhalt der Interzeilen-Permutationsmuster **T** in Tabelle 2 ist in einem internen Festwertspeicher ROM des Turbo-Decodierers gespeichert (255 Bit). Das benötigte Interzeilen-Permutationsmuster sowie die Anzahl der Zeilen R (5 Bit) ergibt sich aus dem vom DSP übermittelten Wert RowSelect. Der Wert RowSelect bestimmt ebenfalls eindeutig die Werte Rpar (4 Bit) und Rpar' (4 Bit).

Die Basissequenz **s** (256*8 Bit = 2 kBit) sowie die Tabellen **prucol** (256*1 Bit) und **prutotcol** (256*8 Bit = 2 kBit) werden in internen Datenspeichern RAM der Turbo-Decodierer-Hardware gespeichert und können durch die Hardware bestimmt werden.

Es wird darauf hingewiesen, dass sämtliche vorstehend angesprochenen Schritte Initialisierungsschritte sind, d.h. nur bei einer Änderung der Blocklänge K durchgeführt werden müssen. Innerhalb eines TTI (Transmit Time Intervall) ist die Blocklänge K konstant. Da ein TTI eine Vielzahl von Datenblöcken umfasst, ist die Neuberechnungsrate für die oben genannten Größen kleiner als die Datenblockrate.

Die Berechnung der aktuellen Adresse I(k) für einen Index (Zeitschritt) k innerhalb eines Verschachteluns-/ Entschachtelungsprozesses wird in dem Hardware-Modul durchgeführt. Die Figuren 13 und 15 können diesbezüglich unmittelbar als Schaltbilddarstellungen des Adressgenerators AG, wie er in der Fig. 2 für den Verschachteler IL und in der Fig. 6 für den Entschachteler DIL' gezeigt ist, interpretiert werden. Wie bereits erwähnt, sind zwei Divisions-/Modulo-Operationen bezüglich R' auszuführen. Wichtig ist, das stets nur ein Zugriff zu den dargestellten Speichern (hierfür müssen beim ersten Ausgführungsbeispiel 3 DRAMs für die zweite Tabelle **pruleftcol** implementiert werden) erforderlich ist. Dies ermöglicht es, die Adresserzeugung (Berechnung von I(k)) innerhalb eines Systemzyklus durchzuführen und dabei ausschließlich Single-Port-Datenspeicher RAM für die genannten Tabellen zu verwenden.

Der Vorteil der beschriebenen Algorithmen bzw. der beschriebenen Schaltungen besteht darin, dass ausschließlich gültige Adressen I(k) (eine pro Zeitschritt k) berechnet werden, die keinen Füllzeichen entsprechen. Die Berechnung der Adressen I(k) erfolgt ohne zeitliche Lücken, d.h. "nahtlos" ("seamless").

Letzteres hat zur Folge, dass die dem Verschachteler IL bzw. dem Entschachteler DIL' nachgeordnete Hardware des Turbo- Decodierers (oder auch des Turbo- Codierers) niemals aufgrund des Ver- oder Entschachtelungsprozesses unterbrochen bzw. angehalten werden muss. Dies bewirkt, dass die Geschwindigkeit der Turbo- Decodierung (Turbo-Codierung) allein durch die Hardware- Resourcen gegeben wird, die für den aktuellen Decodierprozess (Codierprozess) aufgebracht werden. Darüber hinaus ist der Aufwand für die Steuerung des Turbo- Decodiererbetriebs (Turbo- Codierer-Betriebs) bei einer nahtlosen Adresserzeugung signifikant geringer als bei einer lückenden Adresserzeugung.

Da die Initialisierung der ersten, zweiten und dritten Tabellen für die Turbo-Ver- oder -Entschachteler T_IL, IL1, DIL1, DIL2 (konstruktiv: IL, DIL') parallel zu der ersten Turbo-Decodieroperation durchgeführt werden kann, verursacht das erfindungsgemäße Verfahren im Vergleich zu einer Implementierung ohne Nachschlagetabellen (bei der die Bedingung I(k)<k überprüft werden muss) keine Latenz.

4.3 Drittes Ausführungsbeispiel: Erzeugung der inversen Adressen $I^{-1}(k)$

Wie anhand der Figuren 1 bis 6 verdeutlicht, müssen für die Verschachtelung und die Entschachtelung einer Symbolfolge lediglich entweder die Adressen $I(k)$ oder die Adressen $I^{-1}(k)$ berechnet werden. Mit den beiden vorstehend beschriebenen Algorithmen zur Berechnung der Adressen $I(k)$ ist also sowohl das Problem der lückenfreien Adress-Berechnung für die Verschachtelung als auch das Problem der lückenfreien Adress-Berechnung für die Entschachtelung gelöst. Im Folgenden wird ein Algorithmus zur lückenfreien Berechnung der inversen Adressen $I^{-1}(k)$ beschrieben. Wie anhand der Fig. 3 und 5 erläutert, können mit den inversen Adressen $I^{-1}(k)$ gleichfalls sowohl ein Verschachteler (IL') als auch ein Entschachteler (DIL) betrieben werden.

Beispiel 2: UMTS-Verschachtelung für K=43: inverses Verschachtelungs-Permutationsmuster $I^{-1}$

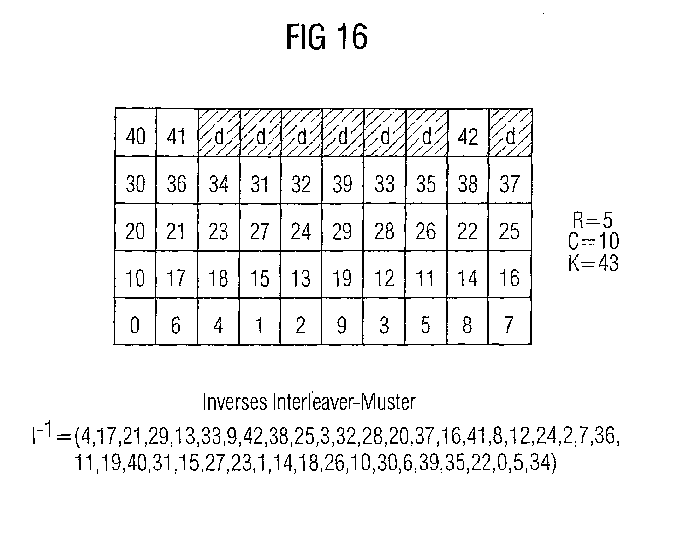

Fig. 16 betrifft das in Fig. 9 erläuterte Beispiel 1 (R=5, C=10, K=43) und zeigt die transformierte Rechteckmatrix sowie das inverse Entschachtelungs- Permutationsmuster $I^{-1}=(I^{-1}(0), I^{-1}(1), ..., I^{-1}(K-1))$. Der k- te Eintrag der Sequenz $I^{-1}$ ist die Adresse (Index) der verschachtelten Symbolfolge, auf welche das k- te nicht verschachtelte Symbol abgebildet wird. Beispielsweise wird das 0- te Symbol der nicht verschachtelten Symbolfolge auf die Position 4 in der verschachtelten Symbolfolge abgebildet. Deshalb gilt $I^{-1}(0)=4$.
Allgemein gelten die Identitäten:

$$I^{-1}(I(k))=k \quad \text{und} \quad I(I^{-1}(k))=k,$$

wobei k=0, 1, ..., K- 1.
Anhand des in Fig. 16 gezeigten Beispiels wird die Adresserzeugung erläutert. Ausgehend von einem Zeitschritt k wird zunächst das Spalten- und Zeilenkoordinatenpaar des Zeitschritts k in der nicht verschachtelten Rechteckmatrix berechnet. Dann wird die Matrixtransformation vorgenommen, d.h. die Zeilenkoordinate nach der Interzeilenpermutation und die Spaltenkoordinate nach der Intrazeilenpermutation bestimmt. $I^{-1}(k)$ ergibt sich dann durch Zählen (in der Leserichtung, siehe Fig. 9) der Anzahl von Symbolen (wobei Füllsymbole nicht mitgezählt werden) zwischen der gerade berechneten Position und dem ersten Symbol in der Rechteckmatrix. Für eine Rechteckmatrix ohne Füllzeichen ergibt sich die einfache Gleichung:

$$I^{-1}(k)=W^{-1}_{T^{-1}(r)}(c) \times R + T^{-1}(r), \qquad [0.18]$$

wobei

$$r=k \bmod C \qquad\qquad [0.19]$$

$$c=k \operatorname{div} C \qquad\qquad [0.20]$$

Dabei entspricht $w_i^{-1}(c)$ dem inversen des Intrazeilen-Permutationsmusters der i-ten permutierten Zeile (siehe Schritt 3.3.5 der UMTS-Spezifiation).
Im Gegensatz zur Situation bei der Berechnung von $I(k)$ verursacht das Vorhandensein von Füllzeichen bei der Berechnung von $I^{-1}(k)$ keine Schwierigkeiten. Die in Gleichung [0.11] definierte erste Tabelle prucol sowie die nach-folgend definierte vierte Tabelle

$$\mathbf{prulefcol} = (\mathtt{prulefcol}(0), ..., \mathtt{prulefcol}(C-1))$$

$$\mathtt{prulefcol}(c) = \sum_{i=0}^{c-1} \mathtt{prucol}(i) \qquad [0.21]$$

reichen für die Korrektur der Matrix-Koordinaten zur Berücksichtigung der Füllzeichen d aus. Die vierte Tabelle **prulefcol** ist nahezu identisch mit der zweiten Tabelle **pruleftcol** und unterscheidet sich von dieser lediglich dadurch, dass der c-te Eintrag der vierten Tabelle die Gesamtanzahl der Füllzeichen vom Zeilenanfang bis zu der Position c **ausschließlich** der Position c angibt.

Bei der Berechnung der inversen Adresse $I^{-1}(k)$ tritt das beim ersten Ausführungsbeispiel beschriebene "Konvergenzproblem" nicht auf, d.h. in der vierten Tabelle **prulefcol** muss stets nur ein einziges Mal zur Berechnung einer inversen Adresse nachgeschlagen werden. Die Schwierigkeit bei der Berechnung der inversen Adresse $I^{-1}(k)$ besteht in der Intrazeilenpermutation, deren Invertierung nicht ohne weiteres ersichtlich ist.

4.3.1 Invertierung des Intrazeilen-Permutationsmusters

Mit $z_i(j)$ wird die Funktion bezeichnet, die das "grundlegende" Intrazeilen-Permutationsmuster auf die i-te verschachtelte Zeile ausübt. Der Begriff "grundlegend" bezeichnet das Intrazeilen-Permutationsmuster ohne die Spalten-Ausnahmehandhabung, d.h.

$$z_i(j) = s(y_{q(i)}(j)) \qquad [0.22]$$

wobei die Funktion $y_{q(i)}(j)$ durch

$$y_{q(i)}(j) = (j \times q(i)) \bmod (p-1) \qquad [0.23]$$

definiert ist.

Das Inverse von $z_i(j)$ lässt sich folgendermaßen ausdrücken

$$Z_i^{-1}(j) = y_{q(i)}^{-1}(s^{-1}(j)) \qquad [0.24]$$

wobei $s^{-1}(j)$ bzw. $y_{q(i)}^{-1}(j)$ die invertierten Größen von $s(j)$ bzw. $y_{q(i)}(j)$ bezeichnen. Gesucht ist die Größe $y_{q(i)}^{-1}(j)$.

Unter der Annahme, dass $y_{q(i)}^{-1}(j)$ in der Form

$$y_{q(i)}^{-1}(j) = (j \times a) \bmod (p-1) \qquad [0.25]$$

geschrieben werden kann, wobei a eine ganze Zahl ist, muss mit Gleichung [0.17] die folgende Beziehung gelten:

$$y_{q(i)}^{-1}(y(j)) = j \times q(i) \times a \bmod (p-1) = j \qquad \text{für alle } j = 0, 1, \ldots, p-2$$
$$[0.26]$$

a muss somit das multiplikative Inverse von q(i) mod (p- 1) sein. Somit ist die ganze Zahl a gesucht, die die Beziehung $a \times q(i) = q(i) \times a = 1 \bmod (p-1)$ erfüllt.

Eine Lösung dieses Problems ergibt sich aus dem Eulerschen Theorem. Dieses besagt, dass die Gleichung

$$x^{\Phi(m)} = 1 \bmod m \qquad [0.27]$$

für beliebige ganze Zahlen x und m gilt, wobei $\Phi$ die Eulersche $\Phi$-Funktion ist:

$$\Phi(m) = \prod_i (p_i - 1) \times p_i^{e_i - 1} \qquad [0.28]$$

wobei $m = \prod p_i^{e_i}$ die Primzahlzerlegung von m ist. Unter Anwendung des Eulerschen Theorems ergibt sich

$$a = q^{-1}(i) = (q(i))^{\Phi(p-1)-1} \bmod (p-1). \qquad [0.29]$$

In der Tabelle 3 sind die Primzahlen p und die zugehörigen Exponenten e=Φ (p- 1)- 1 aufgelistet.

Tabelle 3

| p | e | p | e | p | e | p | e | p | e |
|---|---|---|---|---|---|---|---|---|---|
| 7 | 1 | 47 | 21 | 101 | 39 | 157 | 47 | 223 | 71 |
| 11 | 3 | 53 | 23 | 103 | 31 | 163 | 53 | 227 | 111 |
| 13 | 3 | 59 | 27 | 107 | 51 | 167 | 81 | 229 | 71 |
| 17 | 7 | 61 | 15 | 109 | 35 | 173 | 83 | 233 | 111 |
| 19 | 5 | 67 | 19 | 113 | 47 | 179 | 87 | 239 | 95 |
| 23 | 9 | 71 | 23 | 127 | 35 | 181 | 47 | 241 | 63 |
| 29 | 11 | 73 | 23 | 131 | 47 | 191 | 71 | 251 | 99 |
| 31 | 7 | 79 | 23 | 137 | 63 | 193 | 63 | 257 | 127 |
| 37 | 11 | 83 | 39 | 139 | 43 | 197 | 83 | | |
| 41 | 15 | 89 | 39 | 149 | 71 | 199 | 59 | | |
| 43 | 11 | 97 | 31 | 151 | 39 | 211 | 47 | | |

Beispiel 3: Berechnung des multiplikativen Inversen a

Es soll das multiplikative Inverse $a=q^{-1}$ der Primzahl q=61 mod (83-1) berechnet werden. Gemäß der Tabelle 3 muss $a=61^{39}$ mod 82 berechnet werden.

Zunächst werden nacheinander die Potenzen berechnet.

$b_0 = 61^1 \bmod 82 = 61$
$b_1 = 61^2 \bmod 82 = (b_0 \times b_0) \bmod 82 = 31$
$b_2 = 61^4 \bmod 82 = (b_1 \times b_1) \bmod 82 = 59$
$b_3 = 61^8 \bmod 82 = (b_2 \times b_2) \bmod 82 = 37$
$b_4 = 61^{16} \bmod 82 = (b_3 \times b_3) \bmod 82 = 57$
$b_5 = 61^{32} \bmod 82 = (b_4 \times b_4) \bmod 82 = 51$

Anschließend werden die folgenden Rechenschritte ausgeführt,

$a1 = (b_0 \times b_1) \bmod 82 = 5$
$a2 = (a_1 \times b_2) \bmod 82 = 49$
$a5 = (a_2 \times b_5) \bmod 82 = 39$,

die diejenigen Partialprodukte $b_i$ kombinieren, deren zugehörige Koeffizienten $d_i$ in der binären Zerlegung des Exponenten e=39, d.h.

$$39 = \sum_{i=0}^{5} d_i \times 2^i = 1 \times 2^0 + 1 \times 2^1 + 1 \times 2^2 + 1 \times 2^5,$$

auftritt. Das gewünschte Ergebnis lautet a=$a_5$=39. (Die Identität von e=39 und a=$a_5$=39 ist zufällig.)

Ein Einsetzen der Gleichungen [0.25] und [0.29] in Gleichung [0.24] liefert das Inverse des grundlegenden Intrazeilen-Permutationsmusters.

$$z_i^{-1}(j) = (s^{-1}(j) \times q^{-1}(i)) \bmod (p-1) \qquad [0.30]$$

Für die Invertierung der Intrazeilenpermutationen müssen also die Inversen $s^{-1}$ (j) der Basissequenz s (j) berechnet und gespeichert werden. Da s (j) gemäß Gleichung [0.3] eine Abbildung von {0, 1, ..., p- 2} nach {1, 2, ..., p-1} ist, ist $s^{-1}$ (j) eine Abbildung von {1, 2, ..., p- 1} nach {0, 1, ..., p- 2} . Folglich werden die Werte $s^{-1}$ (j) in einer mit si bezeichneten fünften Tabelle si= (si (0), ..., si (p- 2) ) gespeichert, wobei darauf hingewiesen wird, dass der j- te Eintrag si (j) der Wert $s^{-1}$ (j+1) ist.

Darüber hinaus muss in einer sechsten Tabelle qi der Länge R die Sequenz qi= (qi (0), ..., qi (R- 1) ), deren j-ter Eintrag qi (j) das multiplikative Inverse $q^{-1}$ (j) von q (j) mod (p- 1) gemäß der Gleichung [0.29] ist, gespeichert werden.

Beispiel 4:

Zurückkommend auf das Beispiel 3 ergeben sich gemäß der obigen Diskussion für den betrachteten Verschachteler/Entschachteler (K=43, R=5, C=10, p=11) die folgenden Größen.

**$T^{-1}$** = (4, 3, 2, 1, 0)
**qi** = (1, 3, 1, 7, 3) und
**si** = (0, 1, 8, 2, 4, 9, 7, 3, 6, 5) .

Nachfolgend wird die Beschreibung des kompletten Algorithmus für die Berechnung der inversen Adressen $I^{-1}$ (k) angegeben.

4.3.2 Berechnung der inversen Adresse $I^{-1}$(k)

Zur besseren Lesbarkeit des Algorithmus werden die folgenden Funktionen eingeführt, die die Handhabung der in Schritt 3.3.5 angegebenen Ausnahmebedingungen bei der Intrazeilenpermutation erleichtern:

$$g_{col}(b, c, r, p, K, R, C)$$

$$= \begin{cases} p - 1 & \text{if } c = 0, C > (p-1) \\ p & \text{if } C = p + 1, ((c = p, r \neq 0) \text{ or} \\ & (c = p, r = 0, K \neq R \times C) \text{ or } c = 1, r = 0, K = R \times C)) \\ 0 & \text{if } C = p + 1, c = p, K = R \times C, r = 0 \\ b & \text{else} \end{cases}$$

$$[0.31]$$

$$g_{init}(b, c, p, C) = \begin{cases} p - 1 & \text{if } c = 0, C > (p-1) \\ p & \text{if } c = p, C = (p+1) \\ b & \text{else} \end{cases} \qquad [0.32]$$

Die Funktion $g_{init}$( ) ist ein Spezialfall der Funktion $g_{col}$( ), indem sie lediglich die Spalten-Ausnahmebedingung der teilweise mit Füllzeichen aufgefüllten Zeile betrifft. Während $g_{col}$( ) bei der Berechnung der aktuellen Adressen verwendet wird, wird $g_{init}$( ) lediglich in der Initialisierungsphase für die Berechnung der ersten Tabelle **prucol** und der vierten Tabelle **prulefcol** benötigt.

Nachfolgend wird der Algorithmus zur Berechnung der ersten Tabelle **prucol**, der vierten Tabelle **prulefcol** und der fünften Tabelle **si** angegeben.

4.3.2.1 Algorithmus zur Bestimmung der ersten Tabellen **prucol**, der vierten Tabelle **prulefcol** und der fünften Tabelle **si**

Prinzipiell kann für die Bestimmung der Tabellen **prucol** und **prulefcol** nahezu derselbe Algorithmus wie beim ersten Ausführungsbeispiel (siehe 4.1.1) verwendet werden, wobei eine geringfügige Änderung aufgrund des Unterschieds zwischen den Definitionen der Ausdrücke pruleftcol(c) und prulefcol(c) vorgenommen werden muss. Dies würde es jedoch erforderlich machen, zusätzlich zu der Tabelle **si** die Sequenz **s** zu berechnen und zu speichern. Um die Speicherung der Sequenz **s** zu vermeiden, wird vorgeschlagen, zunächst die Tabelle **si** durch Berechnung und unverzügliche Invertierung von s(j) zu berechnen, danach die erste Tabelle **prucol** mit der Hilfe der fünften Tabelle **si** zu berechnen, und schließlich die vierte Tabelle **prulefcol** allein auf der Basis der ersten Tabelle **prucol** zu berechnen. Bei dieser Vorgehensweise wird kein zusätzlicher Speicherplatz im Vergleich zu der Berechnung der direkten Adresse I(k) benötigt. Ein geringfügiger Nachteil besteht allerdings darin, dass die Tabellen **prucol** und **prulefcol** nicht gleichzeitig erzeugt werden können.

Die Tabellen können mit dem folgenden Algorithmus berechnet werden, wobei die Werte der Variablen K, C, Rpar, R', p, v sowie auch die Werte der Sequenz **qi** vorliegen müssen.

```
/**** determining si *****/
```

```
ss = 1
si[0] = 0
j = 1
while (j < p-1){
 ss = (v*ss) mod p
 si[ss-1] = j
 j = j + 1
}


/**** determining prucol ****/
base = (R'-1) * C
j = 0
while ( base + j < K) { /* non-pruned symbols */
      /* next two lines account for the fact that */
      /* s⁻¹[j] is stored at position j-1 of si[]. */
      /* Because of the -1 in eq. [0.5] no such */
      /* compensation is required for C=p-1 */

      if ((C > p-1) and (j > 0)) h = j-1

      else                              h = j

      b = (si[j]*qi[Rpar]) mod (p-1)
      b' = ginit(b,j,p,C)

      prucol[b']= 0
      j = j + 1
}

while (base + j < C){ /* pruned symbols  */

      /* next two lines account for the fact that */
      /* s⁻¹[j] is stored at position j-1 of si[].  */
      /* Because of the -1 in eq. [0.5] no such  */
      /* compensation is required for C=p-1  */

      if ((C > p-1) and (j > 0))   h = j – 1
      else                              h = j

      b = (si[j]*qi[Rpar]) mod (p-1)
      b' = ginit(b,j,p,C)

      prucol[b'] = 1
      j = j + 1
```

```
}

/**** determining prulefcol ****/

sum = prucol[0]
prulefcol[0] = 0
j = 1
while (j < C) {

    prulefcol[j] = sum
    sum = sum + prucol[j]
    j = j + 1
}
```

Da die maximale Spaltenanzahl $C_{max}$=256 ist, können die Tabellen jeweils in maximal 256 Systemzyklen berechnet werden. Infolgedessen beträgt die maximale Latenz in der Initialisierungsphase 3*256 Systemzyklen, d.h. die maximale Latenz in der Initialisierungsphase für die Berechnung der inversen Adressen $I^{-1}(k)$ ist um 256 Systemzyklen länger als die maximale Latenz für die Berechnung der direkten Adressen I(k) in der Initialisierungsphase. Dabei wird vorausgesetzt, dass die Werte für **qi** (genauso wie die Werte für **q** bei der Berechnung von I(k)) in Firmware, d.h. von dem DSP, berechnet werden.

4.3.2.2 Algorithmus zur Bestimmung der inversen Adressen $I^{-1}(k)$

Zu einem bestimmten Index (Zeitschritt) k wird die Adresse $I^{-1}(k)$ nach dem folgenden Algorithmus berechnet.

```
r1 = k div C
c1 = k mod C
r3 = T^-1[r1]


/* next two lines account for the fact that  */
/* s^-1[j] is stored at position j-1 of si[].  */
/* Because of the -1 in eq. [0.5] no such */
```

```
/* compensation is required for C = p-1     */

if ((C > p-1) and (c1 > 0)) h = c1 - 1
else                        h = c1

c2 = (si[h]*qi[r3] mod (p-1)

/* the following part corresponds to eq. [0.31] for input
b=c2, c=c1 */
c3 = g_col(c2,c1,r3,p,K,R,C)    /* column exception handling */

/* depruning and address generation */
k1 = c3*R' + r3 - prulefcol[c3]

/* final depruning and address generation */
/* the following part corresponds to eq. [0.33] for */
/* input r=r3, k'=k1, c=c3           */

if (r3 > Rpar)  k2 = k1 - ( prutotrow + prucol[c3] )
else {
        if (r3 > Rpar')  k2 = k1 - prutotrow
        else
                if (prutotrow = 2)  k2 = k1 - 1
                else                k2 = k1 - prutotrow
}

kout = k2 /* I⁻¹(k) = kout */
```

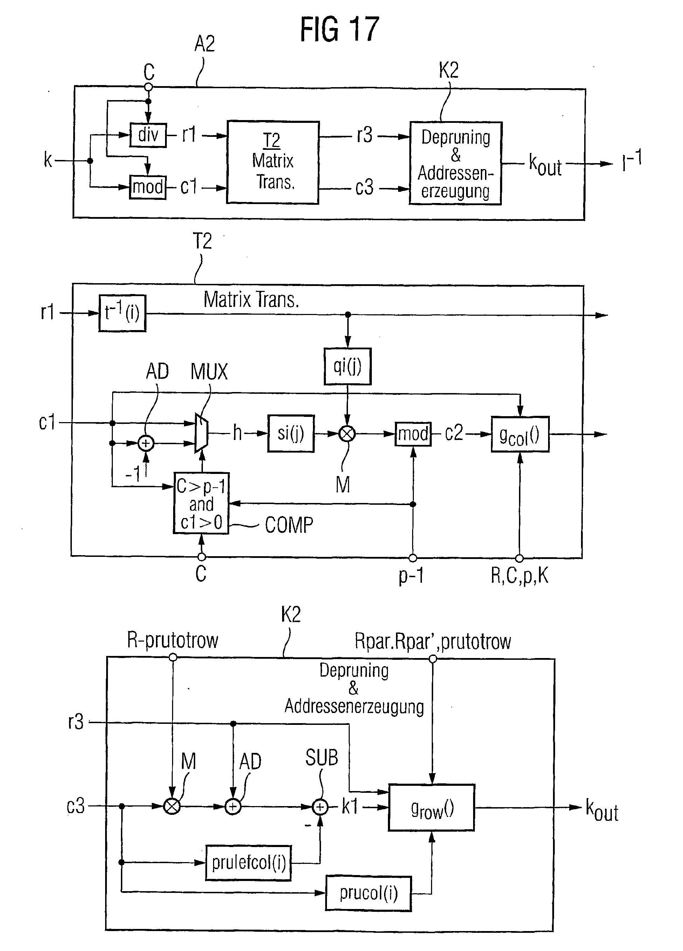

Der Algorithmus ist in Fig. 17 veranschaulicht, wobei zur besseren Lesbarkeit die Funktion

$$g_{row}(r,k',prucol(c),prutotrow,Rpar,Rpar')$$

$$= \begin{cases} k'-prutotrow - prucol(c) & \text{if } r > Rpar \\ k'-1 & \text{if } r \le Rpar', r \le Rpar, prutotrow = 2 \\ k'-prutotrow & \text{else} \end{cases}$$

verwendet wird. Die Funktion $g_{row}(\ )$ korrigiert den Index k' in Abhängigkeit von der Zeilenkoordinate r und den Positionen der vollständig aus Füllzeichen bestehenden Zeilen. Ein Füllzeichen in der teilweise mit Füllzeichen gefüllten Zeile wird ebenfalls berücksichtigt, sofern eine solche Zeile vorhanden ist.

Das Bezugszeichen A2 kennzeichnet den Gesamtalgorithmus. Die vorstehend beschriebene Transformation der Rechteckmatrix wird mittels des Transformationsalgorithmus T2 bewerkstelligt.

Die Hardware-Implementierung des Matrix-Transformationsalgorithmus T2 lässt sich direkt aus der Darstellung des Algorithmus T2 ablesen: Sie umfasst einen Datenspeicher zur Speicherung der Werte t⁻¹(i), einen Datenspeicher zur Speicherung der Werte si(j) und einen Datenspeicher zur Speicherung der Werte qi(j). Ferner umfasst die Schaltung eine Modulo-Stufe mod, einen Multiplexer MUX, welcher von einem Vergleicher COMP angesteuert wird, einen Addierer AD, einen Multiplizierer M und eine Stufe zur Ausführung der Funktion $g_{col}(\ )$. Die Korrektur der mittels des Algorithmus T2 erhaltenen transformierten Matrixkoordinaten (r3,c3) sowie gleichzeitig die Erzeugung der Adresse I⁻¹(k) wird durch den in Fig. 17 veranschaulichten Korrektur- und Adresserzeugungs-Algorithmus K2 vorgenommen. Er umfasst, wie bereits erläutert, das einmalige Nachschlagen der Tabellenwerte prulefcol(i) und prucol(i) in den entsprechenden Tabellen. Seine Hardware-Implementierung lässt sich ebenfalls direkt der Fig. 17 entnehmen. Sie umfasst zwei Datenspeicher zur Speicherung der ersten Tabelle **prucol** und der vierten Tabelle **prulefcol**, sowie einen Multiplizierer M, einen Addierer AD, einen Subtrahierer SUB und eine Stufe zur Ausführung der Funktion $g_{row}( )$.

Im folgenden wird die Umsetzung des Algorithmus A2 nach dem dritten Ausführungsbeispiel in eine Schaltung in beispielhafter Weise erläutert.

Genauso wie bei der Berechnung der direkten Adresse I(k) ist vorgesehen, die Vorbereitungsschritte 3.1.1 und 3.1.2 (Bestimmen von R und C der Rechteckmatrix) sowie 3.3.1 und 3.3.2 (Bestimmen von v und **q**) in Firmware, d.h. mittels des DSP, durchzuführen. Dabei werden die folgenden Parameter berechnet und der Turbo-Decoder-Hardware zur Verfügung gestellt:

- RowSelect (2 Bit) Zeiger auf eines der 4 möglichen Interzeilen-Permutationsmuster nach Tabelle 2
- Primzahl p (9 Bit)
- Primitive Wurzel v (5 Bit)
- Anzahl der Spalten C (9 Bit)
- Liste der multiplikativen Inversen **qi**= (qi($_0$), ..., qi (R- 1) ) (20*7 Bit)
- Anzahl prutotrow (2 Bit) der vollständig mit Füllzeichen gefüllten Zeilen

Zu diesem Zweck müssen sowohl der Inhalt der Tabelle 1 als auch die Exponenten aus der Tabelle 3 (52* (9+5+7) Bit = 1092 Bit) in einem für den DSP verfügbaren Speicher abgelegt sein.

Es ist vorgesehen, die inversen Interzeilen-Permutationsmuster $T^{-1}$ in einem Turbo-Decoder-internen Festwertspeicher ROM (255 Bit) zu speichern. Wie bereits erläutert, können sowohl das entsprechende Muster $T^{-1}$ sowie auch die Anzahl der Zeilen R (5 Bit) in Abhängigkeit von dem Wert von RowSelect bezogen werden. Darüber hinaus bestimmt der Wert RowSelect auch eindeutig die Werte der Variablen Rpar (4 Bit) und Rpar' (4 Bit).

Die in der Initialisierungsphase berechneten Tabellen **si** (256*8 Bit = 2 kBit), **prucol** (256*1 Bit) und **prulefcol** (256*8 Bit = 2 kBit) werden in den Turbo-Decoder-internen flüchtigen Datenspeichern RAM gespeichert und durch die Hardware berechnet.

Die Berechnung der aktuellen inversen Adresse $I^{-1}(k)$ bezüglich eines gegebenen Index (Zeitschritt) k erfolgt in der Hardware. Wie aus der Fig. 17 erkennbar, ist lediglich eine Divisions-/Modulo-Operation in Bezug auf die Spaltenanzahl C erforderlich (im Gegensatz zu den zwei Divisions-/Modulo-Operationen bezüglich R' für das erste und zweite Ausführungsbeispiel zur Berechnung von I(k)). Entscheidend ist auch hier, dass lediglich ein einziger Zugriff auf jede der Tabellen pro Berechnung einer Adresse $I^{-1}(k)$ erforderlich ist, was es ermöglicht, die Berechnung in einem Systemzyklus abzuschließen und ausschließlich Single-Port-RAMs als flüchtige Datenspeicher zu verwenden. Letzteres verbessert die Kompatibilität und Portabilität des Algorithmus.

Der Rechenaufwand zur Bestimmung der Werte der Sequenz qi lässt sich einfach anhand des Beispiels 3 abschätzen. Da der größte in der Tabelle 3 auftretende Exponent den Wert 127 hat, müssen für jede Primzahl q (i) sechs Partialprodukte $b_i$= (q (i) )$^{2i}$ mod p- 1 für i=1, 2, ..., 6 berechnet werden. Anschließend müssen sieben Produkte für die Kombination der Partialprodukte $b_i$ berechnet werden. Insgesamt müssen somit (6+7) *6=78 Multiplikationen (der Wortbreite 16 Bit) und Modulo- Operationen ausgeführt werden.

Die Berechnung der inversen Adressen $I^{-1}(k)$ ist ebenfalls lückenfrei, d.h. jede berechnete Adresse ist eine gültige Adresse für ein Symbol, das kein Füllzeichen ist. Die inversen Intrazeilenpermutationen werden sehr effizient durchgeführt, indem lediglich eine einzige ganze Zahl für jede Zeile (die multiplikativen Inversen **qi**) vorausberechnet wird. Dies vermeidet die Vorausberechnung und Speicherung der gesamten inversen Intrazeilen-Permutationsmuster $T^{-1}$ für jede Zeile, die bei einer weniger geschickten Implementierung erforderlich wäre.

Gemeinsam ist sämtlichen Ausführungsbeispielen, dass sich durch die Erzielung einer nahtlosen Adressgenerierung kein Zeitverlust bei der Anbindung an den nachfolgenden Decodierer ergibt.

5. Verallgemeinerungen der Ausführungsbeispiele für Nicht-UMTS Standards

Die beschriebenen Ausführungsbeispiele lassen sich in für den Fachmann leicht erkennbarer Weise an andere Erzeugungsregeln anpassen:

- Ist anstelle der Definition in Schritt 3.1.1 eine freie (d.h. von dem Parameter K unabhängige) Wahl der Zeilenanzahl R möglich, so kann die Matrixgröße R×C sehr viel größer als K werden. Es können dann mehr als zwei vollständig mit Füllzeichen belegte Zeilen auftreten - im Extremfall bis zu R-1 solcher Zeilen. Anstatt einer einzigen Variablen Rpar', die bisher den Zeilenindex der letzten vollständig mit Füllzeichen belegten Zeile beschreibt, werden mehrere Rpar'-Variablen eingeführt. Die entsprechende Stelle "/* the following part corresponds to eq. [0.16] for input r = r4 */" bis "/* inter-, intra-row permutations and column exception handling */" im Algorithmus 4.1.2 (erstes und zweites Ausführungsbeispiel) und die entsprechende Stelle hinter "/* input r=r3, k'=k1, c=c3 */" im Algorithmus 4.3.2.2 (drittes Ausführungsbeispiel) müssen entsprechend abgeändert werden. Eine andere Möglichkeit besteht darin, ähnlich wie bei der Verwendung der Tabelle **pruleftcol** mit einer verallgemeinerten Tabelle (z.B. **upperrow** genannt) zu arbeiten, die an ihrer r-ten Position die Anzahl von vollständig mit Füllzeichen belegten Zeilen angibt, die von der verwürfelten Zeile r aus gesehen über dieser Zeile r liegen. Mit dieser Information lässt sich das Zurückgehen auf die ursprüngliche Nummerierung der Zeilenindizes effizienter und übersichtlicher formulieren.

- Ist anstelle der Definition in Schritt 3.3.2 eine freie Wahl der Basissequenz **s** möglich (d.h. **s** bildet z.B. nicht wie in Schritt 3.2.2 eine durch ein primitives Element erzeugte zyklische Gruppe), so ändert sich in den betrachteten Algorithmen lediglich der Initialisierungsschritt, der nun die "neue" Konstruktion der Permutation **s** (Basissequenz) implementiert.

- Ist anstelle der Definition in Schritt 3.3.4 eine beliebige Interzeilenpermutation **T** vorgesehen, kann der Fall auftreten, dass für R=5 und R=10 die partiell mit Füllzeichen gefüllten Zeilen nach der Interzeilenpermutation nicht ganz oben in der transformierten Matrix zu liegen kommen. Dieser Fall kann durch eine einfache Maßnahme, nämliche die Änderung der if-Bedingung in den Algorithmen 4.1.2 (erstes und zweites Ausführungsbeispiel) und 4.3.2.2 (drittes Ausführungsbeispiel) an den Stellen von "/* the following part corresponds to eq. [0.16] for input r = r4 */" bis "/* inter-, intra-row permutations and column exception handling */" bzw. nach "/* input r=r3, k'=k1, c=c3 */" berücksichtigt werden. Alternativ bietet sich auch hier wieder die Möglichkeit der Verwendung einer weiteren Tabelle **upperrow** mit den oben genannten Eigenschaften an.

- Ist anstelle der in der Definition in Schritt 3.3.5 angegebenen Intrazeilenpermutation eine andere Intrazeilenpermutation vorgesehen, welche z.B. nicht gemäß der Gleichung

$$W_i(j) = s(((j \times q(i)) \bmod(p-1))) \text{ lautet (Beispiel: } W_i(j) = s(q_i(j)),$$

wobei $q_i(j)$ zur indirekten Adressierung der Basispermutation **s** eine beliebige, möglicherweise nicht-zyklische Permutation beschreibt, die auf andere Weise als durch $(j \times q(i)) \bmod(p-1)$ erzeugt wird) oder sogar auch nicht von Primzahlen $q(i)$ gesteuert sein muss, so ändert sich der Matrix-Transformationsteil der Algorithmen zu den beiden ersten Ausführungsbeispielen dergestalt, dass anstelle der Multiplikation von $q[r5]$ mit c4 und anschließender mod (p-1) Operation die allgemeinere Konstruktionsvorschrift steht. Im Extremfall (ohne eine Intrazeilenpermutation) wäre das ein einfaches, durch die Koordinaten c4 und r5 parametrisiertes Tabellen-Nachschlagen.

Für die Berechnung der inversen Adressen $I^{-1}(k)$ gemäß dem dritten Ausführungsbeispiel (siehe den unter Punkt 4.3.2.1 angegebenen Algorithmus) kann die Vorausberechnung der multiplikativen Inversen mit Hilfe der Eulerschen $\Phi$-Funktion entfallen, da diese nur bei einer Vorschrift gemäß $(j \times q(i)) \bmod(p-1)$ anwendbar ist. Im Falle der allgemeineren Vorschrift $W_i(j) = s(q_i(j))$ ändert sich Fig. 17 dergestalt, dass anstelle der mod(p-1) Multiplikation von $q_i(j)$ mit $s_i(j)$ zuerst $q_i(j)^{-1}$ berechnet wird (z.B. durch Nachschlagen in einer Tabelle) und das Ergebnis anschließend an den Eingang von $s_i(j)$ gelegt wird, vergleiche Gleichung [0.24].

**Patentansprüche**

1. Verfahren zur Berechnung von Verschachtelungs- oder Entschachtelungs-Adressen I(k) für die Adressierung eines Symbolspeichers (RAM) zur Speicherung einer zu verschachtelnden oder zu entschachtelnden Symbolfolge in Abhängigkeit von einem Zeitschrittindex k, wobei die Verschachtelungsvorschrift mittels einer Rechteckmatrix, einer Schreib-Zuordnungsvorschrift der Symbole der nicht verschachtelten Symbolfolge zu den Matrixkoordinaten, dem Auffüllen freier Bereiche der Rechteckmatrix mit Füllzeichen, einer Matrix-Koordinatentransformation und einer Lese-Zuordnungsvorschrift der transformierten Matrixkoordinaten zu der verschachtelten Symbolfolge definiert ist, und wobei in jedem Zeitschritt k die folgenden Schritte durchgeführt werden:

- Berechnen eines Koordinatenpaares (c1,r1) der Rechteckmatrix in Abhängigkeit von k;
- Korrigieren (K1) des Koordinatenpaares (c1,r1) zur Berücksichtigung von Füllzeichen (d);
- Ermitteln des transformierten Koordinatenpaares (c6,r6) zu dem korrigierten Koordinatenpaar (c4,r5) durch Ausführung der Matrix-Koordinatentransformation (T1); und

- Berechnen einer gültigen Verschachtelungs- oder Entschachtelungs-Adresse I(k) aus dem transformierten Koordinatenpaar (c6,r6) gemäß der Schreib-Zuordnungsvorschrift.

2. Verfahren nach Anspruch 1,
**dadurch gekennzeichnet,**

- **dass** die Matrix-Koordinatentransformation eine Matrix-Interzeilenpermutation und eine Matrix-Intrazeilenpermutation umfasst, und
- **dass** das Korrigieren (K1) des Koordinatenpaares (c1, r1) zur Berücksichtigung der Füllzeichen (d) die folgenden Teilschritte umfasst:

-- mehrfaches Nachschlagen von ersten Korrekturwerten $(x_1, x_2, ..., x_n)$ aus einer ersten Tabelle (**pruleftcol**), welche bezüglich einer bestimmten Zeile der Rechteckmatrix zu jeder Spaltenkoordinate eine Information bezüglich der Anzahl der Füllzeichen (d) angibt, die in der bestimmten Zeile vom Zeilenanfang bis zur betrachteten Spaltenkoordinate enthalten sind; und
-- Korrigieren der Spaltenkoordinate in Abhängigkeit von dem zuletzt nachgeschlagenen ersten Korrekturwert $(x_n)$.

3. Verfahren nach Anspruch 1,
**dadurch gekennzeichnet,**

- **dass** die Matrix-Koordinatentransformation eine Matrix-Interzeilenpermutation- und eine Matrix-Intrazeilenpermutation umfasst, und
- **dass** das Korrigieren (K1') des Koordinatenpaares (c1, r1) zur Berücksichtigung der Füllzeichen (d) die folgenden Teilschritte umfasst:

-- einmaliges Nachschlagen eines zweiten Korrekturwertes (x) aus einer zweiten Tabelle (**prutotcol**), welche bezüglich einer bestimmten Zeile der Rechteckmatrix zu jeder Spaltenkoordinate eine Information bezüglich der Anzahl der Füllzeichen (d) angibt, die in der bestimmten Zeile vom Zeilenanfang bis zur betrachteten Spaltenkoordinate und von der betrachteten Spaltenkoordinate bis zum Zeilenende enthalten sind; und
-- Korrigieren der Spaltenkoordinate in Abhängigkeit von dem nachgeschlagenen zweiten Korrekturwert (x).

4. Verfahren nach einem der vorhergehenden Ansprüche,
**dadurch gekennzeichnet,**
**dass** das Koordinatenpaar (c1,r1) nach der Lese-Zuordnungsvorschrift unter Berücksichtigung von Zeilen der transformierten Rechteckmatrix, die vollständig mit Füllzeichen belegt sind, berechnet wird.

5. Verfahren zur Berechnung von inversen Verschachtelungs- oder Entschachtelungs- Adressen $I^{-1}(k)$ für die Adressierung eines Symbolspeichers (RAM) zur Speicherung einer zu verschachtelnden oder zu entschachtelnden Symbolfolge in Abhängigkeit von einem Zeitschrittindex k, wobei eine Verschachtelung eine Umsortierung einer nichtverschachtelten Symbolfolge in eine verschachtelte Symbolfolge nach einem Verschachtelungs- Permutationsmuster I= (I (0), I (1), ..., I (k- 1) ) vornimmt, durch das Verschachtelungsadressen I (0), I (1), ..., I (k- 1) bezeichnet sind, und wobei eine Entschachtelung die von der Verschachtelung vorgenommene Umsortierung nach einem inversen Verschachtelungs- Permutationsmuster $I^{-1} = (I^{-1} (0), I^{-1} (1), ..., I^{-1} (k- 1) )$, durch das inverse Verschachtelungsadressen $I^{-1} (0), I^{-1} (1), ..., I^{-1} (k- 1)$ bezeichnet sind, wieder rückgängig macht, wobei die Verschachtelungsadressen I (0), I (1), ..., I (k- 1) inversen Entschachtelungsadressen und die inversen Verschachtelungsadressen $I^{-1} (0), I^{-1} (1), ..., I^{-1} (k- 1)$ Entschachtelungsadressen entsprechen, wobei die Verschachtelungsvorschrift mittels einer Rechteckmatrix, einer Schreib- Zuordnungsvorschrift der Symbole der nicht verschachtelten Symbolfolge zu den Matrixkoordinaten, dem Auffüllen freier Bereiche der Rechteckmatrix mit Füllzeichen, einer Matrix- Koordinatentransformation und einer Lese- Zuordnungsvorschrift der transformierten Matrixkoordinaten zu der verschachtelten Symbolfolge definiert ist, und wobei in jedem Zeitschritt k die folgenden Schritte durchgeführt werden:

- Berechnen eines Koordinatenpaares (c1, r1) der Rechteckmatrix in Abhängigkeit von k;
- Ermitteln eines transformierten Koordinatenpaares (c3,r3) zu dem Koordinatenpaar (c1,r1) durch Ausführung der inversen Matrix-Koordinatentransformation (T2);
- Berechnen einer gültigen inversen Verschachtelungs- oder Entschachtelungs-Adresse $I^{-1}(k)$ aus dem transformierten Koordinatenpaar (c3,r3) unter Berücksichtigung von Füllzeichen (d), wodurch zu jedem berechneten Koordinatenpaar (c1, r1) eine gültige inverse Verschachtelungs- oder Entschachtelungs-Adresse $I^{-1}(k)$ berech-

net wird.

**6.** Verfahren nach Anspruch 5,
**dadurch gekennzeichnet,**

- **dass** die Matrix-Koordinatentransformation eine Matrix-Interzeilenpermutation und eine Matrix-Intrazeilenpermutation umfasst, und
- **dass** Berechnen einer gültigen inversen Verschachtelungs- oder Entschachtelungs- Adresse $I^{-1}(k)$ aus dem transformierten Koordinatenpaar (c3, r3) unter Berücksichtigung der Füllzeichen (d) die folgenden Teilschritte umfasst:

-- einmaliges Nachschlagen von dritten Korrekturwerten aus einer dritten Tabelle (**prulefcol**), welche bezüglich einer bestimmten Zeile der Rechteckmatrix zu jeder Spaltenkoordinate eine Information bezüglich der Anzahl der Füllzeichen angibt, die in der bestimmten Zeile vom Zeilenanfang bis zur Spaltenkoordinate (c- 1) vor der betrachteten Spaltenkoordinate (c) enthalten sind.

**7.** Verfahren nach Anspruch 5 oder 6,
**dadurch gekennzeichnet,**
**dass** das Koordinatenpaar (c1,r1) der Rechteckmatrix nach der Schreib-Zuordnungsvorschrift berechnet wird.

**8.** Verfahren nach einem der vorhergehenden Ansprüche,
**dadurch gekennzeichnet, dass**
dem Verfahren die Verschachtelungsvorschrift gemäß dem UMTS-Standard 3GPP TS 25.212 V3.11.0 (2002-09) zugrundeliegt.

**9.** Vorrichtung zur Berechnung von Verschachtelungs- oder Entschachtelungs-Adressen I(k) für die Adressierung eines Symbolspeichers (RAM) zur Speicherung einer zu verschachtelnden oder zu entschachtelnden Symbolfolge in Abhängigkeit von einem Zeitschrittindex k, wobei die Verschachtelungsvorschrift mittels einer Rechteckmatrix, einer Schreib-Zuordnungsvorschrift der Symbole der nicht verschachtelten Symbolfolge zu den Matrixkoordinaten, dem Auffüllen freier Bereiche der Rechteckmatrix mit Füllzeichen, einer Matrix-Koordinatentransformation und einer Lese-Zuordnungsvorschrift der transformierten Matrixkoordinaten zu der verschachtelten Symbolfolge definiert ist, die einen Adressgenerator (AG) mit

- einer Koordinatenpaar-Berechnungseinheit zur Berechnung eines Koordinatenpaares (c1,r1) der Rechteckmatrix in Abhängigkeit von k,
- einer Korrektureinheit (K1) zur Korrektur des Koordinatenpaares (c1,r1) zur Berücksichtigung der Füllzeichen (d),
- einer der Korrektureinheit (K1) nachgeordneten Transformationseinheit (T1) zur Berechnung des transformierten Koordinatenpaares (c6,r6) zu dem korrigierten Koordinatenpaar (c4,r5) durch Ausführung der Matrix-Koordinatentransformation, und
- einer Einheit (AD, M) zur Berechnung der Verschachtelungs- oder Entschachtelungs-Adresse I(k) aus dem transformierten Koordinatenpaar (c6,r6)

umfasst.

**10.** Vorrichtung nach Anspruch 9, wobei die Matrixtransformation eine Matrix- Interzeilenpermutation- und eine Matrix-Intrazeilenpermutation umfasst,
**dadurch gekennzeichnet, dass**
die Korrektureinheit (K1) aufweist:

- eine Mehrzahl von ersten Datenspeichern, die jeweils dieselbe erste Tabelle (**pruleftcol**) zum Nachschlagen von ersten Korrekturwerten ($x_1$, $x_2$..., $x_n$) enthalten, wobei die erste Tabelle bezüglich einer bestimmten Zeile der Rechteckmatrix zu jeder Spaltenkoordinate eine Information bezüglich der Anzahl der Füllzeichen (d) angibt, die in der bestimmten Zeile vom Zeilenanfang bis zur betrachteten Spaltenkoordinate enthalten sind.

**11.** Vorrichtung nach Anspruch 9, wobei die Matrixtransformation eine Matrix-Interzeilenpermutation- und eine Matrix-Intrazeilenpermutation umfasst,
**dadurch gekennzeichnet, dass**

die Korrektureinheit (K1') aufweist:

- einen einzigen zweiten Datenspeicher, der eine zweite Tabelle (**prutotcol**) zum Nachschlagen von zweiten Korrekturwerten (x) enthält, wobei die zweite Tabelle (**prutotcol**) bezüglich einer bestimmten Zeile der Rechteckmatrix zu jeder Spaltenkoordinate eine Information bezüglich der Anzahl der Füllzeichen (d) angibt, die in der bestimmten Zeile vom Zeilenanfang bis zur betrachteten Spaltenkoordinate und von der betrachteten Spaltenkoordinate bis zum Zeilenende enthalten sind.

**12.** Vorrichtung zur Berechnung von inversen Verschachtelungs- oder Entschachtelungs- Adressen $I^{-1}(k)$ für die Adressierung eines Symbolspeichers (RAM) zur Speicherung einer zu verschachtelnden oder zu entschachtelnden Symbolfolge in Abhängigkeit von einem Zeitschrittindex k, wobei eine Verschachtelung eine Umsortierung einer nichtverschachtelten Symbolfolge in eine verschachtelte Symbolfolge nach einem Verschachtelungs- Permutationsmuster $I = (I(0), I(1), ..., I(k-1))$ vornimmt, durch das Verschachtelungsadressen $I(0), I(1), ..., I(k-1)$ bezeichnet sind, und wobei eine Entschachtelung die von der Verschachtelung vorgenommene Umsortierung nach einem inversen Verschachtelungs- Permutationsmuster $I^{-1} = (I^{-1}(0), I^{-1}(1), ..., I^{-1}(k-1))$, durch das inverse Verschachtelungsadressen $I^{-1}(0), I^{-1}(1), I^{-1}(k-1)$ bezeichnet sind, wieder rückgängig macht, wobei die Verschachtelungsadressen $I(0), I(1), ..., I(k-1)$ inversen Entschachtelungsadressen und die inversen Verschachtelungsadressen $I^{-1}(0), I^{-1}(1), ..., I^{-1}(k-1)$ Entschachtelungsadressen entsprechen, wobei die Verschachtelungsvorschrift mittels einer Rechteckmatrix, einer Schreib- Zuordnungsvorschrift der Symbole der nicht verschachtelten Symbolfolge zu den Matrixkoordinaten, dem Auffüllen freier Bereiche der Rechteckmatrix mit Füllzeichen, einer Matrix- Koordinatentransformation und einer Lese- Zuordnungsvorschrift der transformierten Matrixkoordinaten zu der verschachtelten Symbolfolge definiert ist, die einen Adressgenerator (AG') mit

- einer Koordinatenpaar- Berechnungseinheit zur Berechnung eines Koordinatenpaares (c1, r1) der Rechteckmatrix in Abhängigkeit von k,
- einer Transformationseinheit (T2) zur Berechnung eines transformierten Koordinatenpaares (c3,r3) zu dem Koordinatenpaar (c1,r1) durch Ausführung der inversen Matrix-Koordinatentransformation, und
- einer Einheit (K2) zum Berechnen einer gültigen inversen Verschachtelungs- oder Entschachtelungs-Adresse $I^{-1}(k)$ aus dem transformierten Koordinatenpaar (c3,r3) unter Berücksichtigung von Füllzeichen (d), wodurch zu jedem berechneten Koordinatenpaar (c1, r1) eine gültige inverse Verschachtelungs- oder Entschachtelungs-Adresse $I^{-1}(k)$ berechnet wird,

umfasst.

**13.** Vorrichtung nach Anspruch 12, wobei die Matrixtransformation eine Matrix-Interzeilenpermutation- und eine Matrix-Intrazeilenpermutation umfasst,
**dadurch gekennzeichnet, dass**
die Einheit (K2) zum Berechnen einer gültigen inversen Verschachtelungs- oder Entschachtelungs-Adresse $I^{-1}(k)$ aufweist:

- einen dritten Datenspeicher, der eine dritte Tabelle (**prulefcol**) zum Nachschlagen von dritten Korrekturwerten enthält, wobei die dritte Tabelle bezüglich einer bestimmten Zeile der Rechteckmatrix zu jeder Spaltenkoordinate eine Information bezüglich der Anzahl der Füllzeichen (d) angibt, die in der bestimmten Zeile vom Zeilenanfang bis zur Spaltenkoordinate (c-1) vor der betrachteten Spaltenkoordinate (c) enthalten sind.

**14.** Vorrichtung nach einem der Ansprüche 10, 11 oder 13,
**dadurch gekennzeichnet, dass**
es sich bei den Datenspeichern um Single-Port-Datenspeicher handelt.

**15.** Turbo-Decodierer, mit einem Verschachteler und einem Entschachteler,
**dadurch gekennzeichnet, dass**
der Symbolspeicher (RAM) des Verschachtelers (IL1) und/oder des Entschachtelers (DIL1, DIL2) durch eine Vorrichtung gemäß einem der Ansprüche 9 bis 14 adressiert wird.

**16.** Turbo-Codierer, mit einem Verschachteler,
**dadurch gekennzeichnet, dass**
der Symbolspeicher (RAM) des Verschachtelers (T_IL) durch eine Vorrichtung gemäß einem der Ansprüche 9 bis 14 adressiert wird.

**Claims**

1. Method for calculating interleaving or de-interleaving addresses I(k) for addressing a symbol memory (RAM) for storing a symbol sequence that is to be interleaved or a symbol sequence that is to be de-interleaved on the basis of a time step index k, wherein the interleaving specification is defined by means of a rectangular matrix, a write association specification for the symbols of the noninterleaved symbol sequence with respect to the matrix co-ordinates, the filling of free areas of the rectangular matrix with fill characters, a matrix co-ordinate transformation and a read association specification for the transformed matrix co-ordinates with respect to the interleaved symbol sequence, and wherein the following steps are performed in each time step k:

    - calculation of a co-ordinate pair (c1, r1) for the rectangular matrix on the basis of k;
    - correction (K1) of the co-ordinate pair (c1, r1) in order to take account of fill characters (d);
    - ascertainment of the transformed co-ordinate pair (c6, r6) for the corrected co-ordinate pair (c4, r5) by virtue of execution of the matrix co-ordinate transformation (T1); and
    - calculation of a valid interleaving or de-interleaving address I(k) from the transformed co-ordinate pair (c6, r6) on the basis of the write association specification.

2. Method according to Claim 1,
   **characterized**

    - **in that** the matrix co-ordinate transformation comprises a matrix inter-row permutation and a matrix intra-row permutation, and
    - **in that** the correction (K1) of the co- ordinate pair (c1, r1) in order to take account of the fill characters (d) comprises the following substeps:

       -- repeated look- up of first correction values ($x_1$, $x_2$, ..., $x_n$) from a first table (**pruleftcol**), which indicates for a particular row of the rectangular matrix, with respect to each column co- ordinate, a piece of information regarding the number of fill characters (d) that the particular row contains from the start of the row to the column co- ordinate under consideration; and
       -- correction of the column co-ordinate on the basis of the most recently looked-up first correction value ($x_n$).

3. Method according to Claim 1,
   **characterized**

    - **in that** the matrix co-ordinate transformation comprises a matrix inter-row permutation and a matrix intra-row permutation, and
    - **in that** the correction (K1') of the co- ordinate pair (c1, r1) in order to take account of the fill characters (d) comprises the following substeps:

       -- single look- up of a second correction value (x) from a second table (**prutotcol**), which indicates for a particular row of the rectangular matrix, with respect to each column co- ordinate, a piece of information regarding the number of fill characters (d) that the particular row contains from the start of the row to the column co- ordinate under consideration and from the column co- ordinate under consideration to the end of the row; and
       -- correction of the column co-ordinate on the basis of the looked-up second correction value (x).

4. Method according to one of the preceding claims,
   **characterized**
   **in that** the co-ordinate pair (c1, r1) is calculated on the basis of the read association specification taking account of rows of the transformed rectangular matrix that are completely occupied by fill characters.

5. Method for calculating inverse interleaving or de- interleaving addresses $I^{-1}$ (k) for addressing a symbol memory (RAM) for storing a symbol sequence that is to be interleaved or a symbol sequence that is to be de- interleaved on the basis of a time step index k, wherein interleaving performs re- sorting of a noninterleaved symbol sequence into an interleaved symbol sequence on the basis of an interleaving permutation pattern I= (I (0), I (1), ..., I (k- 1) ) that denotes interleaving addresses 1 (0), I (1), ..., I (k- 1),  and wherein de- interleaving reverses the re- sorting performed by the interleaving on the basis of an inverse interleaving permutation pattern $I^{-1}$= ($I^{-1}$ (0), $I^{-1}$ (1), ..., $I^{-1}$ (k- 1) ) that denotes inverse interleaving addresses $I^{-1}$ (0), $I^{-1}$ (1), ..., $I^{-1}$ (k- 1), wherein the interleaving addresses I (0), I (1), ..., I (k- 1) correspond to inverse de- interleaving addresses and the inverse interleaving addresses $I^{-1}$ (0), $I^{-1}$ (1), ...., $I^{-1}$ (k- 1) correspond to de- interleaving addresses, wherein the interleaving specification is defined by means of a rectangular matrix, a write association specification for the symbols of the noninterleaved symbol sequence with respect to the matrix co- ordinates, the filling of free areas of the rectangular matrix with fill characters, a matrix co- ordinate transformation and a read association specification for the transformed matrix co- ordinates with respect to the interleaved symbol sequence, and wherein the following steps are performed in each time step k:

- calculation of a co- ordinate pair (c1, r1) for the rectangular matrix on the basis of k;
- ascertainment of a transformed co-ordinate pair (c3, r3) for the co- ordinate pair (c1, r1) by virtue of execution of the inverse matrix co-ordinate transformation (T2);
- calculation of a valid inverse interleaving or de-interleaving address $I^{-1}(k)$ from the transformed co-ordinate pair (c3, r3) taking account of fill characters (d), as a result of which a valid inverse interleaving or de-interleaving address $I^{-1}(k)$ is calculated for each calculated co-ordinate pair (c1, r1).

6. Method according to Claim 5,
**characterized**

- **in that** the matrix co-ordinate transformation comprises a matrix inter-row permutation and a matrix intra-row permutation, and
- **in that** calculation of a valid inverse interleaving or de- interleaving address $I^{-1}$ (k) from the transformed co-ordinate pair (c3, r3) taking account of the fill characters (d) comprises the following substeps:

-- single look- up of third correction values from a third table (**prulefcol**), which indicates for a particular row of the rectangular matrix, with respect to each column co- ordinate, a piece of information regarding the number of fill characters that the particular row contains from the start of the row to the column co-ordinate (c- 1) before the column co- ordinate (c) under consideration.

7. Method according to Claim 5 or 6,
**characterized**
**in that** the co-ordinate pair (c1, r1) of the rectangular matrix is calculated on the basis of the write association specification.

8. Method according to one of the preceding claims,
**characterized in that**
the method is based on the interleaving specification based on the UMTS standard 3GPP TS 25.212 V3.11.0 (2002-09).

9. Apparatus for calculating interleaving or de-interleaving addresses I(k) for addressing a symbol memory (RAM) for storing a symbol sequence that is to be interleaved or a symbol sequence that is to be de-interleaved on the basis of a time step index k, wherein the interleaving specification is defined by means of a rectangular matrix, a write association specification for the symbols of the noninterleaved symbol sequence with respect to the matrix co-ordinates, the filling of free areas of the rectangular matrix with fill characters, a matrix co-ordinate transformation and a read association specification for the transformed matrix co-ordinates with respect to the interleaved symbol sequence, which apparatus comprises an address generator (AG) having

- a co-ordinate pair calculation unit for calculating a co-ordinate pair (c1, r1) for the rectangular matrix on the basis of k,
- a correction unit (K1) for correcting the co-ordinate pair (c1, r1) in order to take account of the fill characters (d),
- a transformation unit (T1), arranged downstream of the correction unit (K1), for calculating the transformed co-ordinate pair (c6, r6) for the corrected co-ordinate pair (c4, r5) by virtue of execution of the matrix co-ordinate transformation, and
- a unit (AD, M) for calculating the interleaving or de-interleaving address I(k) from the transformed co-ordinate pair (c6, r6).

10. Apparatus according to Claim 9, wherein the matrix transformation comprises a matrix inter-row permutation and a matrix intra-row permutation,
**characterized in that**
the correction unit (K1) has:

- a plurality of first data memories that each contain the same first table (**pruleftcol**) for looking up first correction values $(x_1, x_2, ..., x_n)$, wherein the first table indicates for a particular row of the rectangular matrix, with respect to each column co-ordinate, a piece of information regarding the number of fill characters (d) that the particular row contains from the start of the row to the column co-ordinate under consideration.

11. Apparatus according to Claim 9, wherein the matrix transformation comprises a matrix inter-row permutation and a matrix intra-row permutation,
**characterized in that**
the correction unit (K1') has:

- a single second data memory that contains a second table (**prutotcol**) for looking up second correction values (x), wherein the second table (**prutotcol**) indicates for a particular row of the rectangular matrix, with respect to each column co-ordinate, a piece of information regarding the number of fill characters (d) that the particular row contains from the start of the row to the column co-ordinate under consideration and from the column co-ordinate under consideration to the end of the row.

12. Apparatus for calculating inverse interleaving or de- interleaving addresses $I^{-1}(k)$ for addressing a symbol memory (RAM) for storing a symbol sequence that is to be interleaved or a symbol sequence that is to be de- interleaved on the basis of a time step index k, wherein interleaving performs re- sorting of a noninterleaved symbol sequence into an interleaved symbol sequence on the basis of an interleaving permutation pattern $I= (I(0), I(1), ..., I(k-1))$ that denotes interleaving addresses $I(0), I(1), ..., I(k-1)$, and wherein de- interleaving reverses the re- sorting performed by the interleaving on the basis of an inverse interleaving permutation pattern $I^{-1}= (I^{-1}(0), I^{-1}(1), ..., I^{-1}(k-1))$ that denotes inverse interleaving addresses $I^{-1}(0), I^{-1}(1), ..., I^{-1}(k-1)$, wherein the interleaving addresses $I(0), I(1), ..., I(k-1)$ correspond to inverse de- interleaving addresses and the inverse interleaving addresses $I^{-1}(0), I^{-1}(1), ..., I^{-1}(k-1)$ correspond to de- interleaving addresses, wherein the interleaving specification is defined by means of a rectangular matrix, a write association specification for the symbols of the noninterleaved symbol sequence with respect to the matrix co- ordinates, the filling of free areas of the rectangular matrix with fill characters, a matrix co- ordinate transformation and a read association specification for the transformed matrix co- ordinates with respect to the interleaved symbol sequence, which apparatus comprises an address generator (AG') having

- a co- ordinate pair calculation unit for calculating a co- ordinate pair (c1, r1) for the rectangular matrix on the basis of k,
- a transformation unit (T2) for calculating a transformed co-ordinate pair (c3, r3) for the co-ordinate pair (c1, r1) by virtue of execution of the inverse matrix co-ordinate transformation, and
- a unit (K2) for calculating a valid inverse interleaving or de-interleaving address $I^{-1}(k)$ from the transformed co-ordinate pair (c3, r3) taking account of fill characters (d), as a result of which a valid inverse interleaving or de-interleaving address $I^{-1}(k)$ is calculated for each calculated co-ordinate pair (c1, r1).

13. Apparatus according to Claim 12, wherein the matrix transformation comprises a matrix inter-row permutation and a matrix intra-row permutation, **characterized in that**
the unit (K2) for calculating a valid inverse interleaving or de-interleaving address $I^{-1}(k)$ has:

- a third data memory, which contains a third table (**prulefcol**) for looking up third correction values, wherein the third table indicates for a particular row of the rectangular matrix, with respect to each column co-ordinate, a piece of information regarding the number of fill characters (d) that the particular row contains from the start of the row to the column co-ordinate (c-1) before the column co-ordinate (c) under consideration.

14. Apparatus according to one of Claims 10, 11 and 13,
**characterized in that**
the data memories are single-port data memories.

15. Turbo-decoder having an interleaver and a de-interleaver,
**characterized in that**
the symbol memory (RAM) of the interleaver (IL1) and/or of the de-interleaver (DIL1, DIL2) is addressed by an apparatus according to one of Claims 9 to 14.

16. Turbo-coder having an interleaver,
**characterized in that**

the symbol memory (RAM) of the interleaver (T_IL) is addressed by an apparatus according to one of Claims 9 to 14.

**Revendications**

1. Procédé pour le calcul d'adresses d'entrelacement ou de désentrelacement I(k) pour l'adressage d'une mémoire de symboles (RAM) destinée à stocker une séquence de symboles à entrelacer ou à désentrelacer en fonction d'un indice de pas temporel k, dans lequel l'instruction d'entrelacement est définie au moyen d'une matrice rectangulaire, d'une instruction d'affectation en écriture des symboles de la séquence de symboles non entrelacée aux coordonnées de la matrice, du remplissage de zones libres de la matrice rectangulaire avec des symboles de remplissage, d'une transformation de coordonnées matricielles et d'une instruction d'affectation en lecture des coordonnées matricielles transformées en la séquence de symboles entrelacée, et dans lequel, à chaque pas temporel k, les étapes suivantes sont exécutées :

   - calcul d'une paire de coordonnées (c1, r1) de la matrice rectangulaire en fonction de k ;
   - correction (K1) de la paire de coordonnées (c1, r1) pour prendre en compte les symboles de remplissage (d) ;
   - détermination de la paire de coordonnées transformée (c6, r6) en la paire de coordonnées corrigée (c4, r5) en effectuant la transformation de coordonnées matricielles (T1) ; et
   - calcul d'une adresse d'entrelacement ou de désentrelacement valide I(k) à partir de la paire de coordonnées transformée (c6, r6) conformément à l'instruction d'affectation en écriture.

2. Procédé selon la revendication 1, **caractérisé**

   - **en ce que** la transformation de coordonnées matricielles comprend une permutation interlignes de matrice et une permutation intraligne de matrice, et
   - **en ce que** la correction (K1) de la paire de coordonnées (c1, r1) pour prendre en compte les symboles de remplissage (d) comprend les étapes partielles suivantes :

     -- consultation multiple de premières valeurs de correction ($x_1$, $x_2$, ..., $x_n$) dans une première table (**pruleftcol**) qui fournit, par rapport à une ligne déterminée de la matrice rectangulaire et pour chaque coordonnée de colonne, une information concernant le nombre des symboles de remplissage (d) qui sont contenus dans la ligne déterminée du début de la ligne jusqu'à la coordonnée de colonne considérée ; et
     -- correction de la coordonnée de colonne en fonction de la première valeur de correction ($x_n$) consultée en dernier.

3. Procédé selon la revendication 1, **caractérisé**

   - **en ce que** la transformation de coordonnées matricielles comprend une permutation interlignes de matrice et une permutation intraligne de matrice, et
   - **en ce que** la correction (K1') de la paire de coordonnées (c1, r1) pour prendre en compte les symboles de remplissage (d) comprend les étapes partielles suivantes :

     -- consultation unique d'une deuxième valeur de correction (x) dans une deuxième table (**prutotcol**) qui fournit, par rapport à une ligne déterminée de la matrice rectangulaire et pour chaque coordonnée de colonne, une information concernant le nombre des symboles de remplissage (d) qui sont contenus dans la ligne déterminée du début de ligne jusqu'à la coordonnée de colonne considérée et de la coordonnée de colonne considérée jusqu'à la fin de ligne ; et
     -- correction de la coordonnée de colonne en fonction de la deuxième valeur de correction consultée (x).

4. Procédé selon l'une quelconque des revendications précédentes, **caractérisé en ce que** la paire de coordonnées (c1, r1) est calculée conformément à l'instruction d'affectation en lecture en tenant compte de lignes de la matrice rectangulaire transformée qui sont entièrement remplies de symboles de remplissage.

5. Procédé de calcul d'adresses d'entrelacement ou de désentrelacement inverses $I^{-1}$ (k) pour l'adressage d'une mémoire de symboles (RAM) destinée à stocker une séquence de symboles à entrelacer ou à désentrelacer en fonction d'un indice de pas temporel k, dans lequel un entrelacement effectue un réarrangement d'une séquence de symboles non entrelacée en une séquence de symboles entrelacée conformément à un motif de permutation d'entrelacement I= (I (0), I (1), ..., I (k- 1) ), au moyen duquel des adresses d'entrelacement I (0), I (1), ..., I (k- 1) sont définies, et dans lequel un désentrelacement refait en sens inverse le réarrangement effectué par l'entrelacement conformément à un motif de permutation d'entrelacement inverse $I^{-1} = (I^{-1} (0), I^{-1} (1), ..., I^{-1} (k-1)$, au moyen duquel des adresses d'entrelacement inverses $I^{-1} (0), I^{-1} (1), ..., I^{-1} (k-1)$ sont définies, dans lequel les adresses d'entrelacement $I (0), I (1), ..., I (k-1)$ correspondent à des adresses de désentrelacement inverses et les adresses d'entrelacement inverses $I^{-1} (0), I^{-1} (1), ..., I^{-1} (k-1)$ correspondent à des adresses de désentrelacement, dans lequel l'instruction d'entrelacement est définie au moyen d'une matrice rectangulaire, d'une instruction d'affectation en écriture des symboles de la séquence de symboles non entrelacée aux coordonnées matricielles, du remplissage de zones libres de la matrice rectangulaire avec des symboles de remplissage, d'une transformation de coordonnées matricielles et d'une instruction d'affectation en lecture des coordonnées matricielles transformées en la séquence de symboles entrelacée, et dans lequel à chaque pas temporel k, les étapes suivantes sont exécutées :

- calcul d'une paire de coordonnées (c1, r1) de la matrice rectangulaire en fonction de k ;
- détermination d'une paire de coordonnées transformée (c3, r3) en la paire de coordonnées (c1, r1) en effectuant la transformation de coordonnées matricielles inverse (T2) ;
- calcul d'une adresse d'entrelacement ou de désentrelacement inverse valide $I^{-1}(k)$ à partir de la paire de coordonnées transformée (c3, r3) en tenant compte de symboles de remplissage (d), une adresse d'entrelacement ou de désentrelacement inverse valide $I^{-1}(k)$ étant ainsi calculée pour chaque paire de coordonnées calculée (c1, r1).

6. Procédé selon la revendication 5, **caractérisé**

- **en ce que** la transformation de coordonnées matricielles comprend une permutation interlignes de matrice et une permutation intraligne de matrice, et
- **en ce que** le calcul d'une adresse d'entrelacement ou de désentrelacement inverse valide $I^{-1}(k)$ à partir de la paire de coordonnées transformée (c3, r3) en tenant compte des symboles de remplissage (d) comprend les étapes partielles suivantes :

-- consultation unique de troisièmes valeurs de correction dans une troisième table (**pruleftcol**) qui fournit, par rapport à une ligne déterminée de la matrice rectangulaire et pour chaque coordonnée de colonne, une information concernant le nombre des symboles de remplissage qui sont contenus dans la ligne déterminée du début de ligne jusqu'à la coordonnée de colonne (c-1) précédant la coordonnée de colonne considérée (c).

7. Procédé selon la revendication 5 ou 6, **caractérisé en ce que** la paire de coordonnées (c1, r1) de la matrice rectangulaire est calculée conformément à l'instruction d'affectation en écriture.

8. Procédé selon l'une quelconque des revendications précédentes, **caractérisé en ce que** l'instruction d'entrelacement conforme à la norme UMTS 3GPP TS 25.212 V3.11.0 (2002-09) sert de base au procédé.

9. Dispositif de calcul d'adresses d'entrelacement ou de désentrelacement I(k) pour l'adressage d'une mémoire de symboles (RAM) destinée à stocker une séquence de symboles à entrelacer ou à désentrelacer en fonction d'un indice de pas temporel k, dans lequel l'instruction d'entrelacement est définie au moyen d'une matrice rectangulaire, d'une instruction d'affectation en écriture des symboles de la séquence de symboles non entrelacée aux coordonnées matricielles, du remplissage de zones libres de la matrice rectangulaire avec des symboles de remplissage, d'une transformation de coordonnées matricielles et d'une instruction d'affectation en lecture des coordonnées matricielles transformées en la séquence de symboles entrelacée, comprenant un générateur d'adresse (AG) comportant :

- une unité de calcul de paire de coordonnées destinée à calculer une paire de coordonnées (c1, r1) de la matrice rectangulaire en fonction de k,
- une unité de correction (K1) destinée à corriger la paire de coordonnées (c1, r1) pour prendre en compte les symboles de remplissage (d),
- une unité de transformation (T1) en aval de l'unité de correction (K1) destinée à calculer la paire de coordonnées transformée (c6, r6) en la paire de coordonnées corrigée (c4, r5) en effectuant la transformation de coordonnées matricielles, et
- une unité (AD, M) destinée à calculer l'adresse d'entrelacement ou de désentrelacement I(k) à partir de la paire de coordonnées transformée (c6, r6).

10. Dispositif selon la revendication 9, dans lequel la transformation matricielle comprend une permutation interlignes de matrice et une permutation intraligne de matrice, **caractérisé en ce que** l'unité de correction (K1) comprend :

- une pluralité de premières mémoires de données qui contiennent respectivement la même première table (**pruleftcol**) destinée à la consultation de premières valeurs de correction ($x_1$, $x_2$, ..., $x_n$) dans lequel la première table fournit, par rapport à une ligne déterminée de la matrice rectangulaire et pour chaque coordonnée de colonne, une information concernant le nombre des symboles de remplissage (d) qui sont contenus dans la ligne déterminée du début de ligne jusqu'à la coordonnée de colonne considérée.

11. Dispositif selon la revendication 9, dans lequel la transformation de matrice comprend une permutation interlignes de matrice et une permutation intraligne de matrice, **caractérisé en ce que** l'unité de correction (K1') comprend :

- une deuxième mémoire de données unique qui contient une deuxième table (**prutotcol**) destinée à consulter des deuxièmes valeurs de correction (x), dans lequel la deuxième table (**prutotcol**), par rapport à une ligne déterminée de la matrice rectangulaire et pour chaque coordonnée de colonne, fournit une information concernant le nombre des symboles de remplissage (d) qui sont contenus dans la ligne déterminée du début de ligne jusqu'à la coordonnée de colonne considérée et de la coordonnée de colonne considérée jusqu'à la fin de ligne.

12. Dispositif destiné à calculer des adresses d'entrelacement ou de désentrelacement inverses $I^{-1}$ (k) pour l'adressage d'une mémoire de symboles (RAM) destinée à stocker une séquence de symboles à entrelacer ou à désentrelacer en fonction d'un indice de pas temporel k, dans lequel un entrelacement effectue un réarrangement d'une séquence de symboles non entrelacée en une séquence de symboles entrelacée conformément à un motif de permutation d'entrelacement I= (I (0), I (1), ..., I (k- 1), au moyen duquel des adresses d'entrelacement I (0), I (1), ..., I (k- 1) sont définies, et dans lequel un désentrelacement refait en sens inverse le réarrangement effectué par l'entrelacement conformément à un motif de permutation d'entrelacement inverse $I^{-1}$= ($I^{-1}$ (0), $I^{-1}$ (1), ..., $I^{-1}$ (k- 1) ), au moyen duquel des adresses d'entrelacement inverses $I^{-1}$ (0), $I^{-1}$ (1), ..., $I^{-1}$ (k- 1) sont définies, dans lequel les adresses d'entrelacement I (0), I (1), ..., I (k- 1) correspondent à des adresses de désentrelacement inverses et les adresses d'entrelacement inverses $I^{-1}$ (0), $I^{-1}$ (1), ..., $I^{-1}$ (k- 1) ) correspondent à des adresses de désentrelacement, dans lequel l'instruction d'entrelacement est définie au moyen d'une matrice rectangulaire, d'une instruction d'affectation en écriture des symboles de la séquence de symboles non entrelacée aux coordonnées matricielles, du remplissage de zones libres de la matrice rectangulaire avec des symboles de remplissage, d'une transformation de coordonnées matricielles et d'une instruction d'affectation en lecture des coordonnées matricielles transformées en la séquence de symboles entrelacée, qui comprend un générateur d'adresse (AG') comportant

- une unité de calcul de paire de coordonnées destinée à calculer une paire de coordonnées (c1, r1) de la matrice rectangulaire en fonction de k,
- une unité de transformation (T2) destinée à calculer une paire de coordonnées transformée (c3, r3) en la paire de coordonnées (c1, r1) en effectuant la transformation de coordonnées matricielles inverse, et
- une unité (K2) destinée à calculer une adresse d'entrelacement ou de désentrelacement inverse valide $I^{-1}$(k) à partir de la paire de coordonnées transformée (c3, r3) en tenant compte de symboles de remplissage (d), une adresse d'entrelacement ou de désentrelacement inverse valide $I^{-1}$(k) étant ainsi calculée pour chaque paire de coordonnées calculée (c1, r1).

13. Dispositif selon la revendication 12, dans lequel la transformation matricielle comprend une permutation interlignes de matrice et une permutation intraligne de matrice, **caractérisé en ce que** l'unité (K2) destinée à calculer une adresse d'entrelacement ou de désentrelacement inverse valide $I^{-1}$(k) comprend :

- une troisième mémoire de données qui contient une troisième table (**prulefcol**) destinée à la consultation de troisièmes valeurs de correction, dans lequel la troisième table fournit, par rapport à une ligne déterminée de la matrice rectangulaire et pour chaque coordonnée de colonne, une information concernant le nombre des symboles de remplissage (d) qui sont contenus dans la ligne déterminée du début de ligne jusqu'à la coordonnée de colonne (c-1) précédant la coordonnée de colonne considérée (c).

14. Dispositif selon l'une quelconque des revendications 10, 11 ou 13, **caractérisé en ce que** les mémoires de données sont des mémoires de données à un seul port.

15. Turbo-décodeur comportant un entrelaceur et un désentrelaceur, **caractérisé en ce que** la mémoire de symboles (RAM) de l'entrelaceur (IL1) et/ou du désentrelaceur (DIL1, DIL2) est adressée au moyen d'un dispositif selon l'une quelconque des revendications 9 à 14.

**16.** Turbo-codeur comportant un entrelaceur, **caractérisé en ce que** la mémoire de symboles (RAM) de l'entrelaceur (T_IL) est adressée au moyen d'un dispositif selon l'une quelconque des revendications 9 à 14.

# FIG 1

X

| $x_0$ | $x_1$ | $x_2$ | $x_3$ | $x_4$ | $x_5$ | $x_6$ | $x_7$ |
|---|---|---|---|---|---|---|---|

— $x_i$ → $\underline{IL}$ → $y_i$ →

Y

| $y_0$ | $y_1$ | $y_2$ | $y_3$ | $y_4$ | $y_5$ | $y_6$ | $y_7$ |
|---|---|---|---|---|---|---|---|
| $x_7$ | $x_5$ | $x_2$ | $x_6$ | $x_1$ | $x_3$ | $x_0$ | $x_4$ |

# FIG 2

1

$r\overline{w}$

i

AG → $I(i)$ → MUX (1 0) → R/$\overline{W}$ A RAM WD RD

IL

X

| $x_0$ | $x_1$ | $x_2$ | $x_3$ | $x_4$ | $x_5$ | $x_6$ | $x_7$ |
|---|---|---|---|---|---|---|---|

2   3   4   Y

| $y_0$ | $y_1$ | $y_2$ | $y_3$ | $y_4$ | $y_5$ | $y_6$ | $y_7$ |
|---|---|---|---|---|---|---|---|
| $x_7$ | $x_5$ | $x_2$ | $x_6$ | $x_1$ | $x_3$ | $x_0$ | $x_4$ |

| 1)$r\overline{w}$='0' wr-addr=i | data | 2)$r\overline{w}$='1' rd-addr=I(i) |
|---|---|---|
| 0 | 0:$x_0$ | $I(6)=0$ |
| 1 | 1:$x_1$ | $I(4)=1$ |
| 2 | 2:$x_2$ | $I(2)=2$ |
| 3 | 3:$x_3$ | $I(5)=3$ |
| 4 | 4:$x_4$ | $I(7)=4$ |
| 5 | 5:$x_5$ | $I(1)=5$ |
| 6 | 6:$x_6$ | $I(3)=6$ |
| 7 | 7:$x_7$ | $I(0)=7$ |

# FIG 3

# FIG 4

FIG 5

$\overline{rw}$   1

i   AG'   $I^{-1}(i)$   1 0   MUX   R/$\overline{W}$   A   RAM   WD RD   X   DIL

2

3

$y_0$ $y_1$ $y_2$ $y_3$ $y_4$ $y_5$ $y_6$ $y_7$

| $x_7$ | $x_5$ | $x_2$ | $x_6$ | $x_1$ | $x_3$ | $x_0$ | $x_4$ | Y

| $x_0$ | $x_1$ | $x_2$ | $x_3$ | $x_4$ | $x_5$ | $x_6$ | $x_7$ |

1) $\overline{rw}$ = '0'          2) $\overline{rw}$ = '1'
wr-addr = i          rd-addr = $I^{-1}(i)$

| | data | |
|---|---|---|
| 0 | 0: $y_0(x_7)$ | $I^{-1}(7) = 0$ |
| 1 | 1: $y_1(x_5)$ | $I^{-1}(5) = 1$ |
| 2 | 2: $y_2(x_2)$ | $I^{-1}(2) = 2$ |
| 3 | 3: $y_3(x_6)$ | $I^{-1}(6) = 3$ |
| 4 | 4: $y_4(x_1)$ | $I^{-1}(1) = 4$ |
| 5 | 5: $y_5(x_3)$ | $I^{-1}(3) = 5$ |
| 6 | 6: $y_6(x_0)$ | $I^{-1}(0) = 6$ |
| 7 | 7: $y_7(x_4)$ | $I^{-1}(4) = 7$ |

FIG 6

$\overline{rw}$   1

i   AG   $I(i)$   1 0   MUX   R/$\overline{W}$   A   RAM   WD RD   X   DIL'

2

3

$y_0$ $y_1$ $y_2$ $y_3$ $y_4$ $y_5$ $y_6$ $y_7$

| $x_7$ | $x_5$ | $x_2$ | $x_6$ | $x_1$ | $x_3$ | $x_0$ | $x_4$ | Y

| $x_0$ | $x_1$ | $x_2$ | $x_3$ | $x_4$ | $x_5$ | $x_6$ | $x_7$ |

1) $\overline{rw}$ = '0'          2) $\overline{rw}$ = '1'
wr-addr = $I(i)$          rd-addr = i

| | data | |
|---|---|---|
| $I(6) = 0$ | 0: $y_6(x_0)$ | 0 |
| $I(4) = 1$ | 1: $y_4(x_1)$ | 1 |
| $I(2) = 2$ | 2: $y_2(x_2)$ | 2 |
| $I(5) = 3$ | 3: $y_5(x_3)$ | 3 |
| $I(7) = 4$ | 4: $y_7(x_4)$ | 4 |
| $I(1) = 5$ | 5: $y_1(x_5)$ | 5 |
| $I(3) = 6$ | 6: $y_3(x_6)$ | 6 |
| $I(0) = 7$ | 7: $y_0(x_7)$ | 7 |

## FIG 7

## FIG 8

## FIG 9

Schreiben →

| 0 | 1 | 2 | 3 | 4 | 5 | 6 | 7 | 8 | 9 |
|---|---|---|---|---|---|---|---|---|---|
| 10 | 11 | 12 | 13 | 14 | 15 | 16 | 17 | 18 | 19 |
| 20 | 21 | 22 | 23 | 24 | 25 | 26 | 27 | 28 | 29 |
| 30 | 31 | 32 | 33 | 34 | 35 | 36 | 37 | 38 | 39 |
| 40 | 41 | 42 | d | d | d | d | d | d | d |

Inter&intra Zeilen-permutationen ⇒

R=5
C=10
K=43

| 40 | 41 | d | d | d | d | d | d | 42 | d |
|---|---|---|---|---|---|---|---|---|---|
| 30 | 36 | 34 | 31 | 32 | 39 | 33 | 35 | 38 | 37 |
| 20 | 21 | 23 | 27 | 24 | 29 | 28 | 26 | 22 | 25 |
| 10 | 17 | 18 | 15 | 13 | 19 | 12 | 11 | 14 | 16 |
| 0 | 6 | 4 | 1 | 2 | 9 | 3 | 5 | 8 | 7 |

↓ Lesen

Interleaver Muster

I=(40,30,20,10,0,41,36,21,17,6,34,23,18,4,31,27,
15,1,32,24,13,2,39,29,19,9,33,28,12,3,35,26,
11,5,42,38,22,14,8,37,25,16,7,)

## FIG 10

| r | T(r) | r' |
|---|------|-----|
| 0 | 19 | X |
| 1 | 9 | 0 |
| 2 | 14 | 1 |
| 3 | 4 | 2 |
| 4 | 0 | 3 |
| 5 | 2 | 4 |
| 6 | 5 | 5 |
| 7 | 7 | 6 |
| 8 | 12 | 7 |
| 9 | 18 | X |
| 10 | 10 | 8 |
| 11 | 8 | 9 |
| 12 | 13 | 10 |
| 13 | 17 | 11 |
| 14 | 3 | 12 |
| 15 | 1 | 13 |
| 16 | 16 | 14 |
| 17 | 6 | 15 |
| 18 | 15 | 16 |
| 19 | 11 | 17 |

Zeile nur mit Füllzeichen

Zeile nur mit Füllzeichen

R=20    prototrow=2    R'=18
        Rpar=13        Rpar'=9

## FIG 11

C=20

| c | 0 | 1 | 2 | 3 | 4 | 5 | 6 | 7 | 8 | 9 | 10 | 11 | 12 | 13 | 14 | 15 | 16 | 17 | 18 | 19 |
|---|---|---|---|---|---|---|---|---|---|---|----|----|----|----|----|----|----|----|----|----|
| prucol(c) | 1 | 1 | 0 | 1 | 1 | 1 | 1 | 1 | 1 | 0 | 0 | 1 | 1 | 1 | 1 | 0 | 1 | 1 | 1 | 1 |
| pruleftcol(c) | 1 | 2 | 2 | 3 | 4 | 5 | 6 | 7 | 8 | 8 | 8 | 9 | 10 | 11 | 12 | 12 | 13 | 14 | 15 | 16 |

## FIG 12

pruleftcol(c)

R

C

# FIG 13

# FIG 14

C=20

| c | 0 | 1 | 2 | 3 | 4 | 5 | 6 | 7 | 8 | 9 | 10 | 11 | 12 | 13 | 14 | 15 | 16 | 17 | 18 | 19 |
|---|---|---|---|---|---|---|---|---|---|---|----|----|----|----|----|----|----|----|----|----|
| prucol(c) | 1 | 1 | 0 | 1 | 1 | 1 | 1 | 1 | 1 | 0 | 0 | 1 | 1 | 1 | 1 | 0 | 1 | 1 | 1 | 1 |
| prutotcol(c) | 1 | 2 | 2 | 3 | 4 | 6 | 7 | 8 | 8 | 8 | 9 | 11 | 12 | 12 | 13 | 14 | 16 | | | |

# FIG 15

# FIG 16

| 40 | 41 | d | d | d | d | d | d | 42 | d |
|----|----|----|----|----|----|----|----|----|----|
| 30 | 36 | 34 | 31 | 32 | 39 | 33 | 35 | 38 | 37 |
| 20 | 21 | 23 | 27 | 24 | 29 | 28 | 26 | 22 | 25 |
| 10 | 17 | 18 | 15 | 13 | 19 | 12 | 11 | 14 | 16 |
| 0 | 6 | 4 | 1 | 2 | 9 | 3 | 5 | 8 | 7 |

R=5
C=10
K=43

Inverses Interleaver-Muster

$$I^{-1} = (4,17,21,29,13,33,9,42,38,25,3,32,28,20,37,16,41,8,12,24,2,7,36,$$
$$11,19,40,31,15,27,23,1,14,18,26,10,30,6,39,35,22,0,5,34)$$

# FIG 17

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2002159423 A1

**In der Beschreibung aufgeführte Nicht-Patentliteratur**

- **MASERA G et al.** Low-cost IP-blocks for UMTS turbo decoders. *PROC. OF THE 27TH EUROPEAN SOLID-STATE CIRCUITS CONFERENCE 2001,* 2001, 472-475